# EUROPEAN PATENT APPLICATION

(11) **EP 4 497 957 A1**
(43) Date of publication of application: **29.01.2025**
(21) Application number: 24762567.6
(22) Date of filing: 26.02.2024
(51) Int. Cl.: F16C 11/04, H04M 1/02

(54) **ROTATING SHAFT MECHANISM AND ELECTRONIC DEVICE**

(30) Priority: 15.06.2023 CN 202310713284
(71) Applicant: Huawei Technologies Co., Ltd., Shenzhen, Guangdong 518129 (CN)
(72) Inventor: NAGAI, Kenji, Shenzhen, Guangdong 518129 (CN); LIN, Hui, Shenzhen, Guangdong 518129 (CN); ZHONG, Ding, Shenzhen, Guangdong 518129 (CN); FAN, Wen, Shenzhen, Guangdong 518129 (CN)
(74) Representative: Gill Jennings & Every LLP
(86) International application number: PCT/CN2024/078535
(87) International publication number: WO 2024/255310

(57) **Abstract**

This application provides a hinge mechanism and an electronic device. The hinge mechanism includes a base and a rotating module, where the rotating module includes two rotating assemblies that are respectively disposed on two opposite sides of the base. Each rotating assembly includes a swing arm, a housing fastening bracket, a radial rotating arm, and a support arm. The swing arm is rotatably connected to the base, the radial rotating arm is located between the swing arm and the housing fastening bracket, the radial rotating arm is rotatably connected to the swing arm and the housing fastening bracket separately, and a rotation axis of the radial rotating arm extends in a direction in which the housing fastening bracket moves toward or away from the base. The support arm is rotatably connected to the base, and is slidably connected to the housing fastening bracket. An axis through which the support arm rotates around the base and an axis through which the swing arm rotates around the base are parallel to each other, but do not coincide with each other. In addition, the support arm rotates around the base to drive the radial rotating arm to rotate, so that when the electronic device is in a closed state, the radial rotating arm avoids a foldable part of a flexible display. The hinge mechanism has a small size, and can avoid squeezing or pulling on the flexible display in a process of folding and unfolding the hinge mechanism.

## Description

### CROSS-REFERENCE TO RELATED APPLICATIONS

This application claims priority to Chinese Patent Application No. 202310713284.8, filed with the China National Intellectual Property Administration on June 15, 2023 and entitled "HINGE MECHANISM AND ELECTRONIC DEVICE", which is incorporated herein by reference in its entirety.

### TECHNICAL FIELD

This application relates to the field of foldable electronic device technologies, and in particular, to a hinge mechanism and an electronic device.

### BACKGROUND

With gradual maturation of flexible display technologies, a display mode of an electronic device is driven to greatly change. A mobile phone with a foldable flexible display, a tablet computer with a foldable flexible display, a wearable electronic device with a foldable flexible display, and the like are an important evolution direction of intelligent electronic devices in the future.

A flexible display is a key component of a foldable electronic device, and has features of continuity and foldability. A hinge mechanism, as an important component for implementing a folding function of the foldable electronic device, may drive the flexible display to be flattened or bent in a process of unfolding and closing the foldable electronic device. Generally, during a specific design of the hinge mechanism, to avoid the flexible display to avoid pulling or squeezing on the flexible display in a process of folding the electronic device, some components of a rotating assembly in the hinge mechanism need to be thinned. Consequently, structural strength of these components is poor, and structural reliability of the entire hinge mechanism is poor. Based on this, how to make a structure of the hinge mechanism reliable while avoiding pulling or squeezing on the flexible display has become a major problem to be urgently resolved by a person skilled in the art.

### SUMMARY

This application provides a hinge mechanism and an electronic device, to implement a miniaturization design of the hinge mechanism, and improve structural reliability of a flexible display in a rotation process of the hinge mechanism, thereby improving structural reliability of the electronic device.

According to a first aspect, this application provides a hinge mechanism. The hinge mechanism may be used in a foldable electronic device, the hinge mechanism is disposed relative to a foldable part of a flexible display of the electronic device, and the electronic device is unfolded or closed by using the hinge mechanism. When the hinge mechanism is specifically disposed, the hinge mechanism may include a base and a rotating module. The rotating module includes a first rotating assembly and a second rotating assembly, and the first rotating assembly and the second rotating assembly are respectively disposed on two opposite sides of the base. The first rotating assembly may include a first swing arm, a first housing fastening bracket, a first radial rotating arm, and a first support arm. The first swing arm is rotatably connected to the base. The first support arm is rotatably connected to the base, the first support arm is slidably connected to the first housing fastening bracket in a first direction, an axis through which the first support arm rotates around the base and an axis through which the first swing arm rotates around the base are both parallel to a length direction of the base and do not coincide with each other, and the first direction is perpendicular to the length direction of the base. In addition, the first radial rotating arm is located between the first swing arm and the first housing fastening bracket, the first radial rotating arm includes a first connection part, a second connection part, and a first avoidance opening, the first avoidance opening is located between the first connection part and the second connection part, a surface that is of the first radial rotating arm and that is away from the first avoidance opening is a first connection surface, the first connection part is rotatably connected to the first swing arm, the second connection part is rotatably connected to the first housing fastening bracket, and a rotation axis of the first radial rotating arm extends in the first direction.

When the second rotating assembly is specifically disposed, the second rotating assembly may include a second swing arm, a second housing fastening bracket, a second radial rotating arm, and a second support arm. The second swing arm is rotatably connected to the base, the second support arm is rotatably connected to the base, the second support arm is slidably connected to the second housing fastening bracket in a second direction, an axis through which the second support arm rotates around the base and an axis through which the second swing arm rotates around the base are both parallel to a length direction of the base and do not coincide with each other, and the second direction is perpendicular to the length direction of the base. The second radial rotating arm is located between the second swing arm and the second housing fastening bracket, the second radial rotating arm includes a third connection part, a fourth connection part, and a second avoidance opening, the second avoidance opening is located between the third connection part and the fourth connection part, a surface that is of the second radial rotating arm and that is away from the second avoidance opening is a second connection surface, the third connection part is rotatably connected to the second swing arm, the fourth connection part is rotatably connected to the second housing fastening bracket, and a rotation axis of the second radial rotating arm extends in the second direction.

In addition, in the hinge mechanism provided in this application, the base includes an appearance housing that is away from the flexible display, the appearance housing includes a first end and a second end that are opposite to each other, the first end is disposed facing the first housing fastening bracket, and the second end is disposed facing the second housing fastening bracket. When the electronic device is in an unfolded state, the first end of the appearance housing is inserted into the first avoidance opening, and the second end of the appearance housing is inserted into the second avoidance opening. In a process in which the electronic device is switched from the unfolded state to a closed state, the first housing fastening bracket slides relative to the first support arm in a direction away from the base, the second housing fastening bracket slides relative to the second support arm in a direction away from the base, the first support arm rotates around the base to drive the first radial rotating arm to rotate around the first direction, and the second support arm rotates around the base to drive the second radial rotating arm to rotate around the second direction, so that when the electronic device is in the closed state, the first connection surface of the first radial rotating arm does not face the flexible display, and the second connection surface of the second radial rotating arm does not face the flexible display.

In an existing hinge mechanism, because the first swing arm (the second swing arm) is rotatably connected to the base, and is also directly connected to the first housing fastening bracket (the second housing fastening bracket), to enable an electronic device in which the hinge mechanism is used to be unfolded to a flat state, an avoidance opening needs to be provided on the first swing arm (the second swing arm), so that the first swing arm (the second swing arm) avoids the appearance housing. However, because the first swing arm (the second swing arm) further needs to avoid interference to the flexible display in a closed state, a thickness of an avoidance part that is of the first swing arm (the second swing arm) of the existing hinge mechanism and that is disposed away from the avoidance opening can only be designed to be thin, so as to avoid the flexible display. This limits an overall thickness of the hinge mechanism. In other words, if a thickness of the hinge mechanism needs to be further reduced, the thickness of the avoidance part needs to be further reduced. This leads to excessively low structural strength of the part of the first swing arm (the second swing arm), and consequently, it is difficult to ensure structural reliability of the first swing arm (the second swing arm).

However, according to the hinge mechanism provided in this application, when the electronic device is in the unfolded state, the first avoidance opening (the second avoidance opening) of the first radial rotating arm (the second radial rotating arm) may avoid the appearance housing. In a process in which the electronic device rotates from the unfolded state to the closed state, the first housing fastening bracket (the second housing fastening bracket) may rotate around the base to drive the first radial rotating arm (the second radial rotating arm), the first swing arm (the second swing arm), and the first support arm (the second support arm) to rotate around the base together, and the first support arm (the second support arm) may rotate around the base to drive the first radial rotating arm (the second radial rotating arm) to rotate relative to the first swing arm (the second swing arm) and the first housing fastening bracket (the second housing fastening bracket). Therefore, the first connection surface (the second connection surface) of the first radial rotating arm (the second radial rotating arm) rotates toward a side that is away from the flexible display. In such a structural design, a thickness of a part that is of the first radial rotating arm (the second radial rotating arm) and that is used to dispose the first connection surface (the second connection surface) may be flexibly set or even increased according to a strength requirement. In addition, this part rotates in a direction away from the flexible display in a folding process, and does not interfere with the flexible display in the closed state. Therefore, according to the hinge mechanism provided in this application, when the first radial rotating arm (the second radial rotating arm) avoids the appearance housing and the flexible display, structural strength of the entire first radial rotating arm (the second radial rotating arm) can be further ensured. This can help improve structural reliability of the hinge mechanism.

In addition, in the hinge mechanism provided in this application, a motion through which the first housing fastening bracket (the second housing fastening bracket) rotates around the base to drive the first swing arm (the second swing arm) to rotate around the base is level-1 motion transmission with high transmission precision. In addition, because the first swing arm (the second swing arm) is connected to the first housing fastening bracket (the second housing fastening bracket) only by using the first radial rotating arm (the second radial rotating arm), the hinge mechanism has a simple structure and occupies small space. This can help implement miniaturization and a light and thin design of the hinge mechanism.

In addition, according to the hinge mechanism provided in this application, in a process in which the electronic device changes from the unfolded state to the closed state, the first housing fastening bracket and the second housing fastening bracket move toward each other, and the first housing fastening bracket may rotate anticlockwise around the base to drive the first swing arm, the first radial rotating arm, and the first support arm to rotate anticlockwise around the base. The second housing fastening bracket may rotate clockwise around the base to drive the second swing arm, the second radial rotating arm, and the second support arm to rotate synchronously clockwise. In a process in which the electronic device changes from the closed state to the unfolded state, the first housing fastening bracket and the second housing fastening bracket move away from each other, and the first housing fastening bracket may rotate clockwise around the base to drive the first swing arm, the first radial rotating arm, and the first support arm to rotate clockwise around the base. The second housing fastening bracket may rotate anticlockwise around the base to drive the second swing arm, the second radial rotating arm, and the second support arm to rotate synchronously anticlockwise. In this way, folding and unfolding functions of the hinge mechanism can be implemented.

In addition, because an axis through which the first support arm (the second support arm) rotates around the base and an axis through which the first swing arm (the second swing arm) rotates around the base are parallel to each other, but do not coincide with each other, a phase difference exists in a process in which the first swing arm (the second swing arm) and the first support arm (the second support arm) rotate relative to the base. In this way, in a process of folding and unfolding the electronic device, the first support arm (the second support arm) and the first housing fastening bracket (the second housing fastening bracket) may slide relative to each other, so that the first housing fastening bracket and the second housing fastening bracket can move in a direction toward or away from the base. Therefore, in a process in which the first rotating assembly and the second rotating assembly rotate toward each other, the first housing fastening bracket slides in a direction away from a rotation axis center (the base) of the first support arm relative to the first support arm, and the second housing fastening bracket slides in a direction away from a rotation axis center (the base) of the second support arm relative to the second support arm. In this way, extension lengths of the first rotating assembly and the second rotating assembly relative to the base are increased. In addition, in a process in which the first rotating assembly and the second rotating assembly rotate away from each other, the first housing fastening bracket slides in a direction close to the rotation axis center of the first support arm relative to the first support arm, and the second housing fastening bracket slides in a direction close to the rotation axis center of the second support arm relative to the second support arm, so that extension lengths of the first rotating assembly and the second rotating assembly relative to the base are reduced, and a length of the hinge mechanism is reduced. In this way, when the hinge mechanism is in a closed state, an unfolded state, or a folding process, extension lengths of the first rotating assembly and the second rotating assembly relative to the base can adapt to a state of the flexible display, to avoid pulling or squeezing on the flexible display.

In addition, because the foregoing phase difference exists in the process in which the first swing arm (the second swing arm) and the first support arm (the second support arm) rotate relative to the base, the first swing arm (the second swing arm), the first radial rotating arm (the second radial rotating arm), and the first housing fastening bracket (the second housing fastening bracket) have fixed relative positions in the first direction (the second direction). In this case, in a process in which the first support arm (the second support arm) slides relative to the first housing fastening bracket (the second housing fastening bracket), there is also a relative displacement between the first support arm (the second support arm) and the first radial rotating arm (the second radial rotating arm). In this way, the first support arm (the second support arm) can drive the first radial rotating arm (the second radial rotating arm) to rotate around a rotation axis of the first radial rotating arm (the second radial rotating arm).

In a possible implementation of this application, the first radial rotating arm further includes a first avoidance part, the first avoidance part is located between the first connection part and the second connection part, and the first connection part and the second connection part are connected by using the first avoidance part. The first avoidance part and the first avoidance opening are disposed away from each other, and the first connection surface is a surface that is of the first avoidance part and that is away from the first avoidance opening. In a process in which the electronic device changes from the unfolded state to the closed state, the first radial rotating arm may rotate around an axis of the first radial rotating arm, so that when the electronic device is in the closed state, the first connection surface does not face the flexible display. In this design, a thickness of the first avoidance part may be flexibly set or even increased according to a strength requirement. This helps improve structural reliability of the first radial rotating arm, and therefore improves structural reliability of the hinge mechanism.

Similarly, the second radial rotating arm further includes a second avoidance part, the second avoidance part is located between the third connection part and the fourth connection part, and the third connection part and the fourth connection part are connected by using the second avoidance part. The second avoidance part and the second avoidance opening are disposed away from each other, and the second connection surface is a surface that is of the second avoidance part and that is away from the second avoidance opening. In a process in which the electronic device changes from the unfolded state to the closed state, the second radial rotating arm may rotate around an axis of the second radial rotating arm, so that when the electronic device is in the closed state, the second connection surface does not face the flexible display. In this design, a thickness of the second avoidance part may be flexibly set or even increased according to a strength requirement. This helps improve structural reliability of the second radial rotating arm, and therefore improves structural reliability of the hinge mechanism.

In a possible implementation of this application, specifically, when the first radial rotating arm is rotatably connected to the first swing arm and the first housing fastening bracket, the first connection part may be rotatably connected to the first swing arm by using a first rotating shaft, and the second connection part may be rotatably connected to the first housing fastening bracket by using a second rotating shaft. An axis of the first rotating shaft extends in the first direction, and an axis of the second rotating shaft extends in the first direction. In this way, the first radial rotating arm is rotatably connected to the first swing arm and the first housing fastening bracket, and a rotation axis of the first radial rotating arm extends in the first direction.

In a possible implementation of this application, the second connection part may be provided with a first clamping slot, the first housing fastening bracket is provided with a first clamping part, the first clamping part is inserted into the first clamping slot, and the second rotating shaft penetrates a slot wall of the first clamping slot and the first clamping part. In this way, a structure of the first rotating assembly may be compact. This helps reduce a size of the first rotating assembly, and therefore help implement a miniaturization design of the hinge mechanism.

Similarly, the third connection part of the second radial rotating arm is rotatably connected to the second swing arm by using a third rotating shaft, the fourth connection part is rotatably connected to the second housing fastening bracket by using a fourth rotating shaft, an axis of the third rotating shaft extends in the second direction, and an axis of the fourth rotating shaft extends in the second direction. In this way, the second radial rotating arm is rotatably connected to the second swing arm and the second housing fastening bracket, and a rotation axis of the second radial rotating arm extends in the first direction.

In addition, the fourth connection part is provided with a second clamping slot, the second housing fastening bracket is provided with a second clamping part, the second clamping part is inserted into the second clamping slot, and the fourth rotating shaft penetrates a slot wall of the second clamping slot and the second clamping part. In this way, a structure of the second rotating assembly may be compact. This helps reduce a size of the second rotating assembly, and therefore help implement a miniaturization design of the hinge mechanism.

In a possible implementation of this application, the first radial rotating arm further includes a first track slot, the first support arm includes a first guide part, and the first guide part can slide along the first track slot to drive the first radial rotating arm to rotate relative to the first swing arm, so that when the electronic device is in the unfolded state, the first end is inserted into the first avoidance opening. In this application, the first guide part of the first support arm slides along the first track slot of the first radial rotating arm to drive the first radial rotating arm to rotate relative to the first swing arm, so that a structure of the first rotating assembly is simple while the first radial rotating arm rotates.

Similarly, the second radial rotating arm further includes a second track slot, the second support arm includes a second guide part, and the second guide part slides along the second track slot to drive the second radial rotating arm to rotate relative to the second swing arm, so that when the electronic device is in the unfolded state, the second end is inserted into the second avoidance opening. In this application, the second guide part of the second support arm slides along the second track slot of the second radial rotating arm to drive the second radial rotating arm to rotate relative to the second swing arm, so that a structure of the second rotating assembly is simple while the second radial rotating arm rotates.

In this application, a specific disposing form of the first track slot is not limited. For example, the first track slot may be a spiral slot, so that when the first support arm slides in the first direction relative to the first housing fastening bracket, the first radial rotating arm may be driven to rotate relative to the first housing fastening bracket and the first swing arm around an axis extending in the first direction.

In addition, the second track slot may also be a spiral slot, so that when the second support arm slides in the second direction relative to the second housing fastening bracket, the second radial rotating arm may be driven to rotate relative to the second housing fastening bracket and the second swing arm around an axis extending in the second direction.

In a possible implementation of this application, a part connected to the first connection part (the third connection part) of the first radial rotating arm (the second radial rotating arm) is further provided with a first avoidance surface (a second avoidance surface). When the electronic device is in the closed state, the first avoidance surface (the second avoidance surface) may avoid a foldable part of the flexible display. In this way, screen accommodating space formed by the hinge mechanism in the closed state can adapt to a form of the foldable part of the flexible display, so that squeezing on the flexible display can be avoided. This helps improve structural reliability of the flexible display and further improve structural reliability of the electronic device.

In other words, in such a design of the hinge mechanism in this application, the first radial rotating arm (the second radial rotating arm) may rotate in a folding process, so that the avoidance surface and the connection surface are disposed on different surfaces of the first radial rotating arm (the second radial rotating arm). This avoids insufficient strength caused by excessively thinning the avoidance part, or avoids interference caused by the avoidance part to the flexible display.

In a possible implementation of this application, the first guide part may slide along the first track slot to drive the first radial rotating arm to rotate relative to the first swing arm, so that when the electronic device is in the closed state, the first avoidance surface avoids the foldable part of the flexible display. This may prevent the first radial rotating arm from squeezing the foldable part of the flexible display, and helps improve structural reliability of the flexible display.

In addition, the second guide part may slide along the second track slot to drive the second radial rotating arm to rotate relative to the second swing arm, so that when the electronic device is in the closed state, the second avoidance surface avoids the foldable part of the flexible display. This may prevent the second radial rotating arm from squeezing the foldable part of the flexible display, and helps improve structural reliability of the flexible display.

In a possible implementation of this application, the first avoidance surface is an arc-shaped concave surface, and the second avoidance surface is an arc-shaped concave surface. Such a design can better avoid the foldable part of the flexible display. In addition, forms of the first avoidance surface and the second avoidance surface may be further fitted based on an external form of the foldable part of the flexible display when the foldable part of the flexible display is folded, so that when the electronic device is in the closed state, a form of the screen accommodating space formed by the hinge mechanism better adapts to the foldable part of the flexible display. This helps avoid squeezing on the foldable part of the flexible display, and therefore improves structural reliability of the flexible display.

In a possible implementation of this application, the first swing arm may be rotatably connected to the base through a virtual axis. Specifically, the base may be provided with a first arc-shaped groove, the first swing arm includes a first arc-shaped rotating block, the first arc-shaped rotating block is accommodated in the first arc-shaped groove, and the first arc-shaped rotating block may slide along a groove surface of the first arc-shaped groove, to implement rotation of the first swing arm relative to the base. The first swing arm is rotatably connected to the base by using the virtual axis, so that space that is of the base and that is occupied by the first swing arm is small. This helps implement a miniaturization design of the hinge mechanism.

In addition, the base may be further provided with a second arc-shaped groove, and the second swing arm includes a second arc-shaped rotating block. In this case, the second rotating block may be accommodated in the second arc-shaped groove, and the second arc-shaped rotating block may slide along a groove surface of the second arc-shaped groove, to implement rotation of the second swing arm relative to the base. In this application, the second swing arm may also be rotatably connected to the base through a virtual axis, so that space that is of the base and that is occupied by the second swing arm is small. This helps implement a miniaturization design of the hinge mechanism.

In a possible implementation of this application, when the first support arm is specifically slidably connected to the first housing fastening bracket, the first housing fastening bracket may be provided with a first sliding slot, the first support arm is accommodated in the first sliding slot, and the first support arm is capable of sliding in the first sliding slot in the first direction. Similarly, the second housing fastening bracket is provided with a second sliding slot, the second support arm is accommodated in the second sliding slot, and the second support arm is capable of sliding in the second sliding slot in the second direction.

In a possible implementation of this application, the first housing fastening bracket may further include a first mounting slot, a slot wall of the first mounting slot is provided with a first notch, and the first mounting slot communicates with the first sliding slot through the first notch. The hinge mechanism further includes a first damping module. The first damping module includes a first elastic member and a first damping bracket, the first damping bracket includes a first protrusion, the first damping bracket is mounted in the first mounting slot, and under an action of elastic force of the first elastic member, the first protrusion is capable of sliding along the first notch and extending into the first sliding slot. A surface that is of the first support arm and that faces the first mounting slot is further provided with a second protrusion, and when the first protrusion extends into the first sliding slot, opposite side surfaces of the first protrusion and the second protrusion abut against each other in the first direction. In this case, damping force is generated between the first protrusion and the second protrusion, so that the first protrusion blocks the first support arm from continuing sliding along the first sliding slot. In this way, the first housing fastening bracket may be kept at a corresponding rotation position. In addition, in a process in which the first rotating assembly rotates relative to the base, because of existence of the damping force between the first support arm and the first damping module, a user may have an obvious hand feeling of a jerk in a process of unfolding and closing the electronic device, so that user experience is improved.

In addition, the second housing fastening bracket further includes a second mounting slot, a slot wall of the second mounting slot is provided with a second notch, and the second mounting slot communicates with the second sliding slot through the second notch. The hinge mechanism further includes a second damping module. The second damping module includes a second elastic member and a second damping bracket, the second damping bracket includes a third protrusion, the second damping bracket is mounted in the second mounting slot, and under an action of elastic force of the second elastic member, the third protrusion is capable of sliding along the second notch and extending into the second sliding slot. A surface that is of the second support arm and that faces the second mounting slot is further provided with a fourth protrusion, and when the third protrusion extends into the second sliding slot, opposite side surfaces of the third protrusion and the fourth protrusion abut against each other in the second direction. In this case, damping force is generated between the third protrusion and the fourth protrusion, so that the third protrusion blocks the second support arm from continuing sliding along the second sliding slot, and the second housing fastening bracket can be kept at a corresponding rotation position. In addition, in a process in which the second rotating assembly rotates relative to the base, because of existence of the damping force between the second support arm and the second damping module, a user may have an obvious hand feeling of a jerk in a process of unfolding and closing the electronic device, so that user experience is improved.

In a possible implementation of this application, the first support arm includes two first connection arms that are disposed opposite to each other, the two first connection arms are slidably connected to the first housing fastening bracket, and the first damping module is located between the two first connection arms. In this way, a structure of the first rotating assembly may be compact. This helps reduce a size of the first rotating assembly, and therefore helps implement a miniaturization design of the hinge mechanism.

Similarly, the second support arm may include two second connection arms that are disposed opposite to each other, the two second connection arms are slidably connected to the second housing fastening bracket, and the second damping module is located between the two second connection arms. In this way, a structure of the second rotating assembly is compact. This helps reduce a size of the second rotating assembly, and therefore helps implement a miniaturization design of the hinge mechanism.

In a possible implementation of this application, the first rotating assembly further includes a first support plate. The first support plate includes a first plate surface and a second plate surface that are disposed back to back, the first plate surface is configured to support the flexible display, the second plate surface is provided with a third track slot, the first support arm is provided with a first guide structure, the first guide structure is inserted into the third track slot, and the first guide structure is capable of sliding along the third track slot. In addition, the second rotating assembly further includes a second support plate. The second support plate includes a third plate surface and a fourth plate surface that are disposed back to back, the third plate surface is configured to support the flexible display, the fourth plate surface is provided with a fourth track slot, the second support arm is provided with a second guide structure, the second guide structure is inserted into the fourth track slot, and the second guide structure is capable of sliding along the fourth track slot. When the first housing fastening bracket and the second housing fastening bracket rotate toward each other, the first housing fastening bracket drives the first support arm to rotate around the base, and the first guide structure slides along the third track slot, to drive the first support plate to rotate relative to the first housing fastening bracket, and drive an end that is of the first support plate and that is close to the base to move in a direction away from the base. The second housing fastening bracket drives the second support arm and the second swing arm to rotate around the base, and the second guide structure slides along the third track slot, to drive the second support plate to rotate relative to the second housing fastening bracket, and drive an end that is of the second support plate and that is close to the base to move in a direction away from the base, so that screen accommodating space for accommodating a bendable part of the flexible display is formed between the first support plate, the base, and the second support plate.

In addition, the first housing fastening bracket further includes a fifth track slot, the first rotating assembly further includes a third support plate, the third support plate includes a first sliding part and a first support arm, the first sliding part is inserted into the fifth track slot, the first housing fastening bracket rotates around the base to drive the third support plate to rotate around the base, and the first sliding part slides along the fifth track slot. The first support plate includes a third sliding slot, and the first support part is capable of sliding along the third sliding slot. The first support part includes a fifth plate surface. When the electronic device is in the closed state, the third support plate avoids the first swing arm. When the electronic device is in the unfolded state, the third support plate is located on a side that is of the first swing arm and that faces the flexible display, and the first plate surface and the fifth plate surface are connected to form a support surface for supporting the flexible display. This helps improve integrity of the support surface that is of the hinge mechanism and that is configured to support the flexible display, thereby implementing smoothly supporting the flexible display.

Similarly, the second housing fastening bracket further includes a sixth track slot, the second rotating assembly further includes a fourth support plate, the fourth support plate includes a second sliding part and a second support part, the second sliding part is inserted into the sixth track slot, the second housing fastening bracket rotates around the base to drive the fourth support plate to rotate around the base, and the second sliding part slides along the sixth track slot. In addition, the second support plate includes a fourth sliding slot, the second support part is capable of sliding along the fourth sliding slot, and the second support part includes a sixth plate surface for supporting the flexible display. When the electronic device is in the closed state, the fourth support plate avoids the second swing arm. When the electronic device is in the unfolded state, the fourth support plate is located on a side that is of the second swing arm and that faces the flexible display, and the third plate surface and the sixth plate surface are connected to form a support surface for supporting the flexible display. This helps improve integrity of the support surface that is of the hinge mechanism and that is configured to support the flexible display, thereby implementing smoothly supporting the flexible display.

In this application, specific disposing forms of the fifth track slot and the third sliding slot are not limited. For example, the fifth track slot is a linear slot, and the third sliding slot is a linear slot. In this case, the first sliding part is capable of sliding in the fifth track slot relative to the first housing fastening bracket in a third direction, and the first support part is capable of sliding in the third sliding slot relative to the first support plate in a fourth direction. When the electronic device is in the closed state, an included angle between the third direction and the fourth direction is greater than 0°, so that the first housing fastening bracket and the first support plate limit a motion of the third support plate toward the base. In this way, fall-off of the third support plate can be avoided.

In addition, the sixth track slot may be a linear slot, and the fourth sliding slot may also be a linear slot. The second sliding part is capable of sliding in the sixth track slot relative to the second housing fastening bracket in a fifth direction, the second support part is capable of sliding in the fourth sliding slot relative to the second support plate in a sixth direction, and when the electronic device is in the closed state, an included angle between the fifth direction and the sixth direction is greater than 0°, so that the second housing fastening bracket and the second support plate limit a motion of the fourth support plate toward the base. In this way, fall-off of the fourth support plate can be avoided.

In a possible implementation of this application, the third support plate may further include a first abutting part. When the electronic device is in the closed state, the first abutting part abuts against the first housing fastening bracket, and the first housing fastening bracket provides support force for the first abutting part in a direction away from the base. Therefore, fall-off of the third support arm in the closed state can be avoided, to improve structural reliability of the first rotating assembly, and further improve structural reliability of the hinge mechanism.

Similarly, the fourth support plate further includes a second abutting part. When the electronic device is in the closed state, the second abutting part abuts against the second housing fastening bracket, and the second housing fastening bracket provides support force for the second abutting part in a direction away from the base. Therefore, fall-off of the fourth support arm in the closed state can be avoided, to improve structural reliability of the second rotating assembly, and further improve structural reliability of the hinge mechanism.

In a possible implementation of this application, the base may further include a bearing surface. The bearing surface may be configured to support the flexible display, and when the electronic device is in the closed state, the bearing surface, the first support surface, and the third support surface may form a support surface for supporting the flexible display. This helps improve integrity of the support surface that is of the hinge mechanism and that is configured to support the flexible display, thereby implementing smoothly supporting the flexible display.

According to a second aspect, this application further provides an electronic device, where the electronic device includes a first housing, a second housing, and the hinge mechanism in the first aspect. The first housing and the second housing are respectively disposed on two opposite sides of the hinge mechanism, a first housing fastening bracket is fastened to the first housing, and a second housing fastening bracket is fastened to the second housing. A flexible display continuously covers the first housing, the second housing, and the hinge mechanism, and the flexible display is fastened to the first housing and the second housing. When the electronic device is in an unfolded state, the hinge mechanism, the first housing, and the second housing jointly support the flexible display smoothly, so as to ensure that a form of the electronic device in the unfolded state is complete. In a process in which the electronic device changes from the unfolded state to a closed state, the two housings rotate toward each other to drive the flexible display to rotate. This can effectively avoid deformation of the flexible display, to reduce a risk of damage to the flexible display.

### BRIEF DESCRIPTION OF DRAWINGS

FIG. 1 is a diagram of a structure of an electronic device in a closed state according to an embodiment of this application;
FIG. 2 is a diagram of a structure of an electronic device in an unfolded state according to an embodiment of this application;
FIG. 3 is a diagram of a structure of a hinge mechanism according to an embodiment of this application;
FIG. 4 is an exploded diagram of a hinge mechanism according to an embodiment of this application;
FIG. 5 is a diagram of a structure of a first swing arm according to an embodiment of this application;
FIG. 6 is a diagram of a structure of a base according to an embodiment of this application;
FIG. 7 is a diagram of a structure of a first housing fastening bracket according to an embodiment of this application;
FIG. 8 is a diagram of a structure of a first radial rotating arm when an electronic device is in an unfolded state according to an embodiment of this application;
FIG. 9 is a top view of a hinge mechanism when an electronic device is in an unfolded state according to an embodiment of this application;
FIG. 10 is a sectional view at A-A of the hinge mechanism shown in FIG. 9;
FIG. 11 is a diagram of a structure of the hinge mechanism shown in FIG. 10 when an electronic device is in an intermediate state;
FIG. 12 is a diagram of a structure of the hinge mechanism shown in FIG. 10 when an electronic device is in a closed state;
FIG. 13 is a diagram of a structure of a first radial rotating arm of the hinge mechanism shown in FIG. 12;
FIG. 14 is a diagram of a cooperation relationship between a first radial rotating arm and a first support arm according to an embodiment of this application;
FIG. 15a is a diagram of a partial structure of a hinge mechanism according to an embodiment of this application;
FIG. 15b is another diagram of a partial structure of a hinge mechanism according to an embodiment of this application;
FIG. 15c is another diagram of a partial structure of a hinge mechanism according to an embodiment of this application;
FIG. 16 is a diagram of a structure of a first damping module according to an embodiment of this application;
FIG. 17 is another sectional view of a hinge mechanism when an electronic device is in a closed state according to an embodiment of this application;
FIG. 18 is another sectional view of a hinge mechanism when an electronic device is in a closed state according to an embodiment of this application;
FIG. 19a is another sectional view of a hinge mechanism when an electronic device is in a closed state according to an embodiment of this application;
FIG. 19b is another sectional view of a hinge mechanism when an electronic device is in a closed state according to an embodiment of this application; and
FIG. 20 is a diagram of a structure of the hinge mechanism shown in FIG. 19a when an electronic device is in an unfolded state.

### Reference numerals:

1: hinge mechanism; 101: base; 1011: first arc-shaped groove; 1012: second arc-shaped groove; 1013: appearance housing;
10131: first end; 10132: second end; 10133: appearance surface; 1014: bearing surface;
102: rotating module;
1021: first rotating assembly; 10211: first swing arm; 102111: first arc-shaped rotating block; 102112: first mounting hole;
102113: first rotating shaft; 10212: first radial rotating arm; 102121: first connection part; 102122: second connection part;
1021221: first clamping slot; 102123: first avoidance opening; 102124: first avoidance surface; 102125: first track slot;
102126: first avoidance part; 1021261: first connection surface;
10213: first housing fastening bracket; 102131: first clamping part; 1021311: second rotating shaft; 102132: first sliding slot;
102133: first mounting slot; 1021331: first notch; 1021332: first limiting post; 102134: first rotating slot;
102135: fifth track slot; 10214: first support arm;
102141: first guide part; 102142: first connection arm; 1021421: second protrusion; 102143: first guide structure;
10215: first damping module; 102151: first elastic member; 102152: first damping bracket; 1021521: first protrusion;
1021522: first limiting part;
10216: first support plate; 102161: first plate surface; 102162: second plate surface; 102163: first rotating part;
102164: first guide member; 1021641: third track slot; 102165: third sliding slot;
10217: third support plate; 102171: first sliding part; 102172: first support part; 1021721: fifth plate surface;
102173: first abutting part;
1022: second rotating assembly; 10221: second swing arm; 102211: second arc-shaped rotating block; 102212: third mounting hole;
102213: third rotating shaft; 10222: second radial rotating arm; 102221: third connection part; 102222: fourth connection part;
1022221: second clamping slot; 102223: second avoidance opening; 102224: second avoidance surface; 102225: second track slot;
102226: second avoidance part; 1022261: second connection surface;
10223: second housing fastening bracket; 102231: second clamping part; 1022311: fourth rotating shaft; 102232: second sliding slot;
102233: second mounting slot; 1022331: second notch; 1022332: second limiting post; 102234: second rotating slot;
102235: sixth track slot; 10224: second support arm; 102241: second guide part; 102242: second connection arm;
1022421: fourth protrusion; 102243: second guide structure;
10225: second damping module; 102251: second elastic member; 102252: second damping bracket; 1022521: third protrusion;
1022522: second limiting part;
10226: second support plate; 102261: third plate surface; 102262: fourth plate surface; 102263: second rotating part;
102264: second guide member; 1022641: fourth track slot; 102265: fourth sliding slot;
10227: fourth support plate; 102271: second sliding part; 102272: second support part; 1022721: sixth plate surface;
102273: second abutting part;
2: first housing; 3: second housing; 4: flexible display; and 5: screen accommodating space.

### DESCRIPTION OF EMBODIMENTS

To make the objectives, technical solutions, and advantages of this application clearer, the following further describes this application in detail with reference to the accompanying drawings. Terms used in the following embodiments of this application are merely intended to describe specific embodiments, but are not intended to limit this application. The singular expressions "one", "a/an", "the", "the foregoing", "this" and "the one" as used in this specification and the appended claims of this application are also intended to include expressions such as "one or more", unless otherwise specified in the context clearly.

Reference to "an embodiment", "some embodiments", or the like described in this specification indicates that one or more embodiments of this application include a specific feature, structure, or characteristic described with reference to the embodiment or embodiments. Therefore, statements such as "in an embodiment", "in some embodiments", "in some other embodiments", and "in other embodiments" that appear at different places in this specification do not necessarily mean referring to a same embodiment. Instead, the statements mean "one or more but not all of embodiments", unless otherwise specifically emphasized in another manner. The terms "include", "have", and their variants all mean "include but are not limited to", unless otherwise specifically emphasized in another manner.

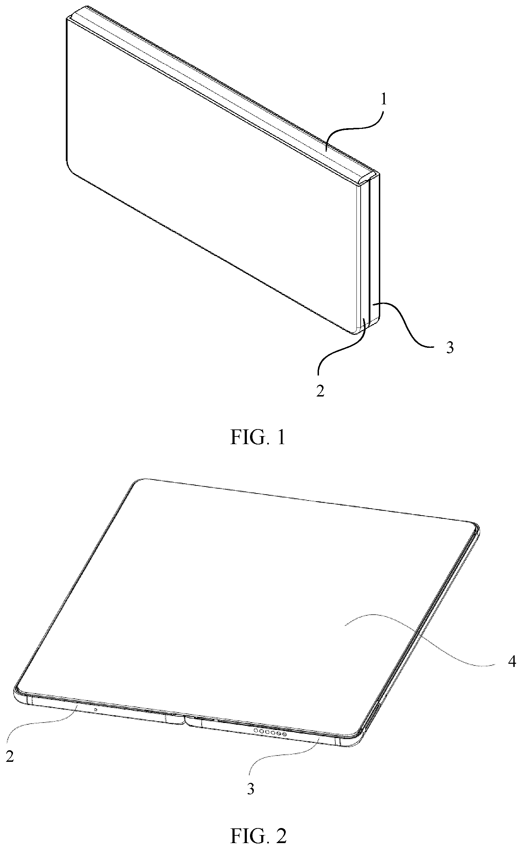

To facilitate understanding of the hinge mechanism and the electronic device provided in embodiments of this application, the following first describes an application scenario of the hinge mechanism and the electronic device. The hinge mechanism may be used in, but is not limited to, a foldable electronic device like a mobile phone, a palmtop computer (personal digital assistant, PDA), a notebook computer, or a tablet computer. When the hinge mechanism provided in embodiments of this application is used in an electronic device, refer to FIG. 1. FIG. 1 is a diagram of a structure of an electronic device according to an embodiment of this application. In the embodiment shown in FIG. 1, the electronic device is in a closed state. In addition to the hinge mechanism 1, the electronic device may further include two housings and a flexible display (not shown in FIG. 1). For ease of description, in this application, the two housings of the electronic device may be respectively named as a first housing 2 and a second housing 3. The first housing 2 and the second housing 3 are located on two sides of the hinge mechanism 1, and can rotate around the hinge mechanism 1. The electronic device provided in this application may be an inward-foldable electronic device. When being used, the electronic device may be closed and unfolded based on different usage scenarios.

FIG. 2 is a diagram of a structure of an electronic device in an unfolded state. It can be learned from FIG. 2 that, in the unfolded state, the first housing 2 and the second housing 3 are still located on two sides of the hinge mechanism 1, and the first housing 2 and the second housing 3 may support a flexible display 4, so that the flexible display 4 is in a flat state.

It may be understood that, a process in which the electronic device changes from the unfolded state shown in FIG. 2 to the closed state shown in FIG. 1, or a process in which the electronic device changes from the closed state shown in FIG. 1 to the unfolded state shown in FIG. 2 is a process in which the first housing 2 and the second housing 3 rotate around the hinge mechanism 1, and in the foregoing process, the first housing 2 and the second housing 3 may drive the flexible display 4 to fold or unfold accordingly. As a key functional component in the foldable electronic device, the hinge mechanism 1 may be disposed corresponding to a foldable part of the flexible display 4. Therefore, the hinge mechanism 1 is important in supporting the foldable part of the flexible display 4 when the electronic device is in the unfolded state shown in FIG. 2, and in accommodating the foldable part of the flexible display 4 when the electronic device is in the closed state shown in FIG. 1. In a case in which space formed by the first housing 2, the second housing 3, and the hinge mechanism 1 cannot meet a folding requirement of the flexible display 4 when the electronic device is in the closed state, or an extension length of a support surface provided by the first housing 2, the second housing 3, and the hinge mechanism 1 is inconsistent with an unfolding length of the flexible display 4 when the electronic device is in the unfolded state, the flexible display 4 may be squeezed or pulled. After the electronic device performs a plurality of folding operations, the flexible display 4 is likely to be damaged.

In addition, during a specific design of the existing hinge mechanism 1, to avoid the flexible display 4 to avoid pulling or squeezing on the flexible display 4 in a process of folding the electronic device, some components of a rotating assembly in the hinge mechanism 1 need to be thinned. Consequently, structural strength of these components is poor, and structural reliability of the entire hinge mechanism 1 is poor.

The hinge mechanism 1 provided in this application is intended to resolve the foregoing problem, so that in a process in which the first housing 2 and the second housing 3 of the electronic device rotate around the hinge mechanism 1, the components of the hinge mechanism 1 may always avoid the foldable part of the flexible display 4 when the components of the hinge mechanism 1 meet a strength requirement. In addition, the screen accommodating space formed by the first housing 2, the second housing 3, and the hinge mechanism 1 when the electronic device is in the closed state meets a folding requirement of the flexible display 4, and the extension length of the support surface formed by the first housing 2, the second housing 3, and the hinge mechanism 1 in the unfolded state can adapt to the unfolding length of the flexible display 4, so that deformation of the flexible display 4 can be avoided, and a squeeze or pull stress on the flexible display 4 can be reduced. Therefore, a service life of the flexible display 4 is prolonged and reliability of the electronic device is improved. To facilitate understanding of the hinge mechanism 1 provided in embodiments of this application, the following describes a specific structure of the hinge mechanism in detail with reference to the accompanying drawings.

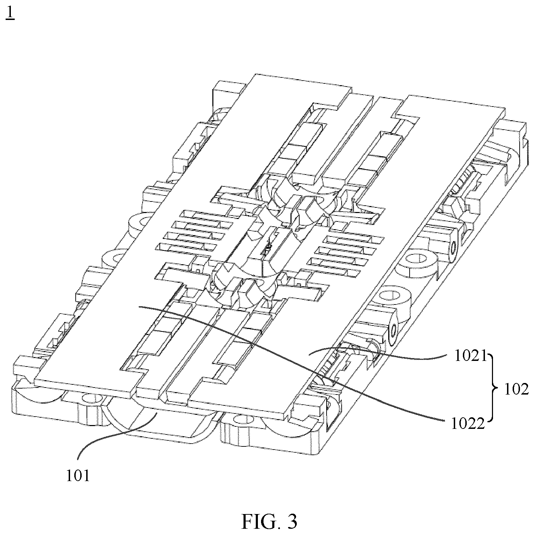

First, refer to FIG. 3. FIG. 3 is a diagram of a structure of the hinge mechanism 1 according to an embodiment of this application. In this application, the hinge mechanism 1 may include a base 101 and a rotating module 102. A quantity of rotating modules 102 in the hinge mechanism 1 is not limited in this application. The hinge mechanism 1 may include only one rotating module 102, or may include a plurality of rotating modules 102. When the hinge mechanism 1 includes a plurality of rotating modules 102, the plurality of rotating modules 102 may be arranged at intervals in an axial direction of the hinge mechanism 1. In this application, the axial direction of the hinge mechanism 1 is an extension direction of an axis through which the first housing 2 shown in FIG. 2 rotates around the hinge mechanism 1 and an axis through which the second housing 3 shown in FIG. 2 rotates around the hinge mechanism 1. It may be understood that, the first housing 2 and the second housing 3 are rotatably connected by using the plurality of rotating modules 102, so that stability of rotation of the first housing 2 and the second housing 3 of the electronic device relative to the hinge mechanism 1 can be effectively improved.

In this application, the rotating module 102 includes a first rotating assembly 1021 and a second rotating assembly 1022. The first rotating assembly 1021 and the second rotating assembly 1022 are located on two opposite sides of the base 101, and the first rotating assembly 1021 and the second rotating assembly 1022 are rotatably connected to the base 101. In this application, a process in which the electronic device with the hinge mechanism 1 changes from an unfolded state to a closed state is a process in which the first rotating assembly 1021 and the second rotating assembly 1022 rotate toward each other around the base 101. A process in which the electronic device changes from the closed state to the unfolded state is a process in which the first rotating assembly 1021 and the second rotating assembly 1022 rotate away from each other around the base 101.

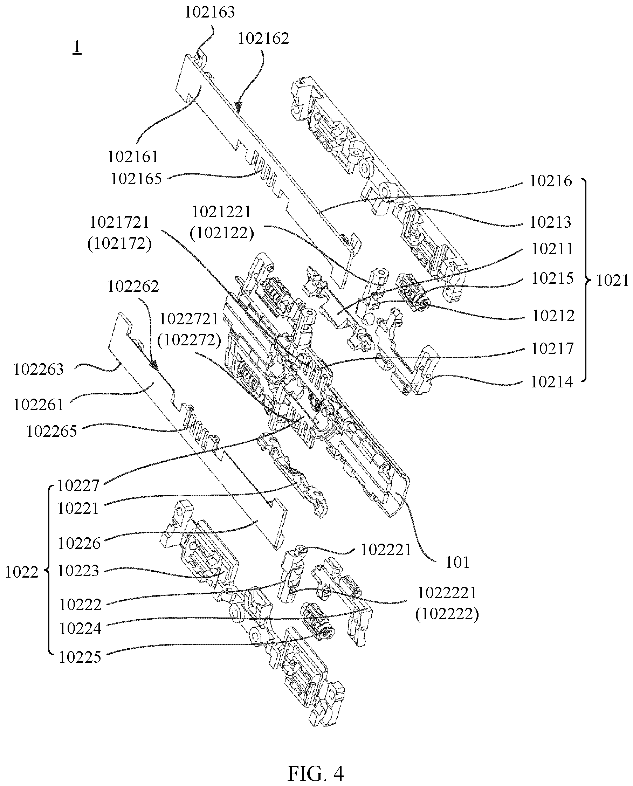

To facilitate understanding of a structure of the rotating module 102, refer to FIG. 4. FIG. 4 is an exploded view of the hinge mechanism 1 according to an embodiment of this application. The first rotating assembly 1021 may include a first swing arm 10211, and the first swing arm 10211 is rotatably connected to the base 101. The first swing arm 10211 may be rotatably connected to the base 101 through a virtual axis. This can help reduce space occupied by the first swing arm 10211 on the base 101, help reduce a size of the rotating module 102, and implement a miniaturization design of the hinge mechanism 1.

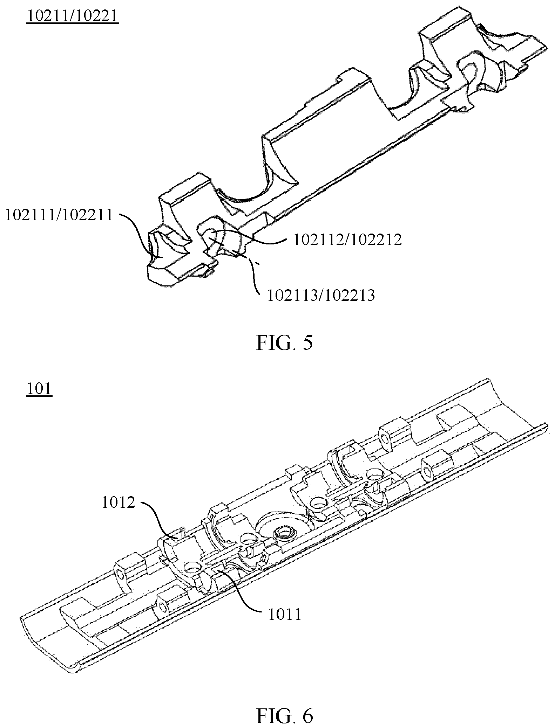

It should be noted that, in this application, the virtual axis is an axis center of a circular arc-shaped structure. Two parts that are rotatably connected may rotate relative to the virtual axis, and a position of the virtual axis is fixed as the two parts that are rotatably connected rotate relative to each other. For example, FIG. 5 is a diagram of a structure of the first swing arm 10211 according to an embodiment of this application. Refer to FIG. 4 and FIG. 5 together. A first arc-shaped rotating block 102111 may be disposed at an end that is of the first swing arm 10211 and that faces the base 101. In addition, FIG. 6 is a diagram of a structure of the base 101 according to an embodiment of this application. In this application, a first arc-shaped groove 1011 may be provided on the base 101. In this case, the first arc-shaped rotating block 102111 may be accommodated in the first arc-shaped groove 1011, and the first arc-shaped rotating block 102111 may slide along a groove surface of the first arc-shaped groove 1011, so that the first swing arm 10211 rotates around the base 101 by sliding the first arc-shaped rotating block 102111 along the groove surface of the first arc-shaped groove 1011.

In this application, the first arc-shaped rotating block 102111 may be, but is not limited to, a circular arc-shaped rotating block, and the first arc-shaped groove 1011 may be, but is not limited to, a circular arc-shaped groove. It may be understood that, when the first arc-shaped rotating block 102111 is a circular arc-shaped rotating block, a surface that is of the first arc-shaped rotating block 102111 and that is in contact with the groove surface of the first arc-shaped groove 1011 may be a circular arc-shaped surface, the groove surface of the first arc-shaped groove 1011 is also a circular arc-shaped surface, and circle centers of the two circular arc-shaped surfaces coincide with each other.

It should be noted that, in some possible embodiments of this application, the first swing arm 10211 and the base 101 may alternatively be rotatably connected through a solid axis, so that reliability of the rotatable connection between the first swing arm 10211 and the base 101 can be improved, and structural reliability of the hinge mechanism 1 is improved.

Still refer to FIG. 4. The first rotating assembly 1021 may further include a first radial rotating arm 10212 and a first housing fastening bracket 10213, where the first radial rotating arm 10212 is located between the first swing arm 10211 and the first housing fastening bracket 10213, and the first radial rotating arm 10212 is rotatably connected to the first swing arm 10211. In addition, the first radial rotating arm 10212 is rotatably connected to the first housing fastening bracket 10213. During specific implementation, the first radial rotating arm 10212 includes a first connection part 102121 and a second connection part 102122, where the first connection part 102121 is rotatably connected to the first swing arm 10211, and the second connection part 102122 is rotatably connected to the first housing fastening bracket 10213.

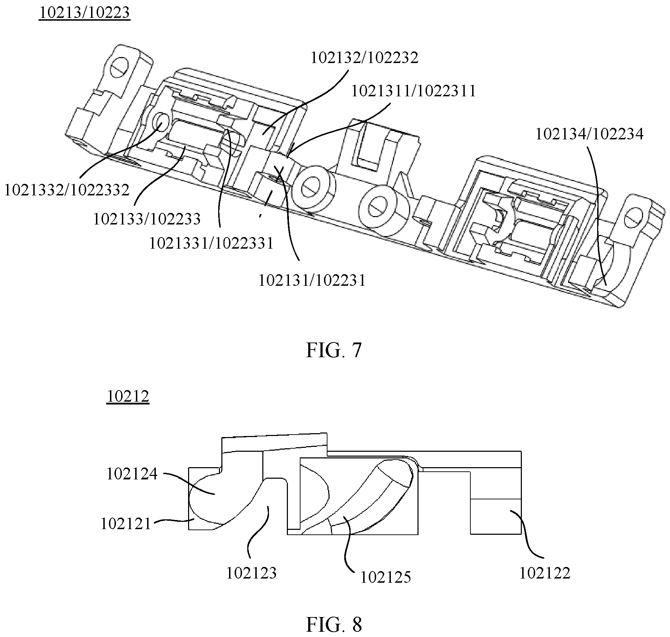

Refer to FIG. 4 and FIG. 5 together. In this application, the first connection part 102121 of the first radial rotating arm 10212 may be rotatably connected to the first swing arm 10211 by using the first rotating shaft 102113, and an axis of the first rotating shaft 102113 extends in a first direction. In addition, refer to FIG. 4 and FIG. 7 together. FIG. 7 is a diagram of a structure of the first housing fastening bracket 10213 according to an embodiment of this application. The second connection part 102122 may be rotatably connected to the first housing fastening bracket 10213 by using the second rotating shaft 1021311, and an axis of the second rotating shaft 1021311 extends in the first direction. In this case, a rotation axis of the first radial rotating arm 10212 extends in the first direction. The first direction is a length direction perpendicular to the base 101, and may also be understood as a direction in which the first housing fastening bracket 10213 moves toward or away from the base 101.

In addition, in this embodiment of this application, relative positions of the first swing arm 10211, the first radial rotating arm 10212, and the first housing fastening bracket 10213 are fixed in the first direction. During specific implementation, still refer to FIG. 5. The first swing arm 10211 may be provided with a first mounting hole 102112. In addition, the first connection part 102121 of the first radial rotating arm 10212 shown in FIG. 4 may be provided with a second mounting hole (not shown in FIG. 4), and the first rotating shaft 102113 may penetrate both the first mounting hole 102112 and the second mounting hole. In order to enable relative positions of the first swing arm 10211 and the first radial rotating arm 10212 to be fixed in the first direction, a stop part may be separately disposed on two end parts of the first rotating shaft 102113. Therefore, while limiting the first swing arm 10211 and the first radial rotating arm 10212 in the first direction, the first radial rotating arm 10212 may further rotate relative to the first swing arm 10211. In this application, specific structures of the two stop parts are not limited. For example, the two stop parts may be snap rings, or the first rotating shaft 102113 may be disposed as a rivet, and the rivet may be riveted with the first swing arm 10211. In this case, only one snap ring needs to be disposed at an end part that is of the first rotating shaft 102113 and that passes through the first connection part 102121. In some other possible embodiments of this application, the first swing arm 10211 and the first radial rotating arm 10212 may alternatively be limited in the first direction in another possible manner. Details are not described one by one herein.

When the first radial rotating arm 10212 is connected to the first housing fastening bracket 10213, as shown in FIG. 4, the second connection part 102122 of the first radial rotating arm 10212 may be provided with a first clamping slot 1021221. In addition, as shown in FIG. 7, the first housing fastening bracket 10213 is provided with a first clamping part 102131, and the first clamping part 102131 may be inserted into the first clamping slot 1021221. In this case, the second rotating shaft 1021311 may penetrate both a slot wall of the first clamping slot 1021221 and the first clamping part 102131, so that the first radial rotating arm 10212 may further rotate relative to the first housing fastening bracket 10213 while being limited with the first housing fastening bracket 10213 in the first direction. In some other possible embodiments of this application, the first radial rotating arm 10212 and the first housing fastening bracket 10213 may be further limited in the first direction in another possible manner. For example, a stop part may be separately disposed on two end parts of the second rotating shaft 1021311 with reference to the foregoing connection manner of the first radial rotating arm 10212 and the first swing arm 10211, so that the first swing arm 10211 and the first radial rotating arm 10212 are limited in the first direction.

In a possible embodiment of this application, the first radial rotating arm 10212 may alternatively be rotatably connected to both the first housing fastening bracket 10213 and the first swing arm 10211 by using a same rotating shaft, to simplify a structure of the first rotating assembly 1021, and help improve consistency of rotation of the first swing arm 10211, the first radial rotating arm 10212, and the first housing fastening bracket 10213 around the base 101.

It can be learned from the foregoing description of the connection relationship between the first swing arm 10211, the first radial rotating arm 10212, and the first housing fastening bracket 10213 that relative positions of the three are fixed in the first direction. Therefore, the first housing fastening bracket 10213 may rotate around the base 101 to drive the first radial rotating arm 10212 and the first swing arm 10211 to rotate around the base 101 together, and a moving trajectory in which the three rotate around the base 101 is the same. It can be learned that, a motion through which the first housing fastening bracket 10213 drives the first swing arm 10211 to move around the base 101 is level-1 motion transmission with high transmission precision. In addition, because the first swing arm 10211 is connected to the first housing fastening bracket 10213 only by using the first radial rotating arm 10212, the first swing arm 10211 has a simple structure, and occupies small space. This can help implement miniaturization and a light and thin design of the hinge mechanism 1.

It should be noted that, as shown in FIG. 4, when the hinge mechanism 1 includes a plurality of rotating modules 102, two first rotating assemblies 1021 of two adjacent rotating modules 102 may share one first swing arm 10211. In this case, the first swing arm 10211 may be provided with two first arc-shaped rotating blocks 102111, and the first swing arm 10211 may be rotatably connected to the two first radial rotating arms 10212. This can help simplify a structure of the hinge mechanism 1, and enable the structure of the hinge mechanism 1 to be compact.

As shown in FIG. 4, the first rotating assembly 1021 may further include a first support arm 10214, and the first support arm 10214 is rotatably connected to the base 101. In addition, an axis through which the first support arm 10214 rotates around the base 101 and an axis through which the first swing arm 10211 rotates around the base 101 are both parallel to a length direction of the base 101 and do not coincide with each other. In addition, in the embodiment shown in FIG. 4, the first support arm 10214 may be rotatably connected to the base 101 by using a pin shaft, to improve reliability of the rotatable connection between the first support arm 10214 and the base 101.

Still refer to FIG. 4. The first support arm 10214 is slidably connected to the first housing fastening bracket 10213 in the first direction. As shown in FIG. 7, the first housing fastening bracket 10213 is provided with a first sliding slot 102132, the first support arm 10214 is accommodated in the first sliding slot 102132, and the first support arm 10214 is capable of sliding in the first direction in the first sliding slot 102132. In addition, to improve reliability of the slidable connection between the first support arm 10214 and the first housing fastening bracket 10213, a first sliding rail may be disposed in the first sliding slot 102132, and a first sliding block may be disposed on the first support arm 10214. In this way, the first sliding block may be clamped on the first sliding rail, so that the first sliding rail may guide sliding of the first support arm 10214 along the first housing fastening bracket 10213 while the first support arm 10214 is limited to the first housing fastening bracket 10213.

In this application, the second rotating assembly 1022 may be disposed with reference to the first rotating assembly 1021. Specifically, refer to FIG. 4. The second rotating assembly 1022 may include a second swing arm 10221. A structure of the second swing arm 10221 may also be shown in FIG. 5. A second arc-shaped rotating block 102211 is disposed at an end that is of the second swing arm 10221 and that faces the base 101. In addition, as shown in FIG. 6, the base 101 is provided with a second arc-shaped groove 1012, the second arc-shaped rotating block 102211 may be accommodated in the second arc-shaped groove 1012, and the second arc-shaped rotating block 102211 may slide along a groove surface of the second arc-shaped groove 1012, therefore, the second swing arm 10221 is rotatably connected to the base 101 by sliding the second arc-shaped rotating block 102211 along an arc-shaped surface of the second arc-shaped groove 1012.

In this application, the second arc-shaped rotating block 102211 may be, but is not limited to, a circular arc-shaped rotating block, and the second arc-shaped groove 1012 may be, but is not limited to, a circular arc-shaped groove. It may be understood that, when the second arc-shaped rotating block 102211 is a circular arc-shaped rotating block, a surface that is of the second arc-shaped rotating block 102211 and that is in contact with the groove surface of the second arc-shaped groove 1012 may be a circular arc-shaped surface, the groove surface of the second arc-shaped groove 1012 is also a circular arc-shaped surface, and circle centers of the two circular arc-shaped surfaces coincide with each other.

It should be noted that, in some possible embodiments of this application, the second swing arm 10221 and the base 101 may alternatively be rotatably connected through a solid axis, so that reliability of the rotatable connection between the second swing arm 10221 and the base 101 can be improved, and structural reliability of the hinge mechanism 1 is improved.

In addition, as shown in FIG. 4, the second rotating assembly 1022 may further include a second radial rotating arm 10222 and a second housing fastening bracket 10223, where the second radial rotating arm 10222 is located between the second swing arm 10221 and the second housing fastening bracket 10223, and the second radial rotating arm 10222 includes a third swing connection part 102221 and a fourth connection part 102222. The third connection part 102221 is rotatably connected to the second swing arm 10221, and the fourth connection part 102222 is rotatably connected to the second housing fastening bracket 10223. During specific implementation, refer to FIG. 4 and FIG. 5 together. The third connection part 102221 of the second radial rotating arm 10222 is rotatably connected to the second swing arm 10221 by using the third rotating shaft 102213, and an axis of the third rotating shaft 102213 extends in a second direction. In addition, refer to FIG. 4 and FIG. 7 together. The fourth connection part 102222 is rotatably connected to the second housing fastening bracket 10223 by using the fourth rotating shaft 1022311, and an axis of the fourth rotating shaft 1022311 extends in the second direction. In this case, a rotation axis of the second radial rotating arm 10222 extends in the second direction. The second direction is perpendicular to a length direction of the base, and may also be understood as a direction in which the second housing fastening bracket 10223 moves toward or away from the base 101.

In this embodiment of this application, relative positions of the second swing arm 10221, the second radial rotating arm 10222, and the second housing fastening bracket 10223 are fixed in the second direction. A manner of fastening the relative positions of the second swing arm 10221 and the second radial rotating arm 10222 in the second direction may be set with reference to a manner of fastening the relative positions of the first swing arm 10211 and the first radial rotating arm 10212 in the first direction. Simply, the third rotating shaft 102213 may penetrate both the third mounting hole 102212 on the second swing arm 10221 and the fourth mounting hole of the third connection part 102221 of the second radial rotating arm 10222. In addition, a stop part is separately disposed on two end parts of the third rotating shaft 102213. A manner of fastening the relative positions of the second radial rotating arm 10222 and the second housing fastening bracket 10223 in the second direction may be set with reference to a manner of fastening the relative positions of the first radial rotating arm 10212 and the first housing fastening bracket 10213 in the first direction. Simply, as shown in FIG. 4, the fourth connection part 102222 may be provided with a second clamping slot 1022221. In addition, as shown in FIG. 7, the second housing fastening bracket 10223 is provided with a second clamping part 102231, the second clamping part 102231 is inserted into the second clamping slot 1022221, and the fourth rotating shaft 1022311 penetrates a slot wall of the second clamping slot 1022221 and the second clamping part 102231.

In a possible embodiment of this application, the second radial rotating arm 10222 may alternatively be rotatably connected to both the second housing fastening bracket 10223 and the second swing arm 10221 by using a same rotating shaft, to simplify a structure of the second rotating assembly 1022, and help improve consistency of rotation of the second swing arm 10221, the second radial rotating arm 10222, and the second housing fastening bracket 10223 around the base 101.

Because relative positions of the second swing arm 10221, the second radial rotating arm 10222, and the second housing fastening bracket 10223 are fixed in the second direction, the second swing arm 10221 may rotate around the base 101 to drive the second radial rotating arm 10222 and the second housing fastening bracket 10223 to rotate around the base 101 together, and a moving trajectory in which the three rotate around the base 101 is the same. It can be learned that a motion through which the second swing arm 10221 drives the second housing fastening bracket 10223 to move around the base 101 is level-l motion transmission with high transmission precision. In addition, because the second swing arm 10221 is connected to the second housing fastening bracket 10223 only by using the second radial rotating arm 10222, the second swing arm 10221 has a simple structure, and occupies small space. This can help implement miniaturization and a light and thin design of the hinge mechanism 1.

In this application, the second rotating assembly 1022 may further include a second support arm 10224, and the second support arm 10224 is rotatably connected to the base 101. In addition, an axis through which the second support arm 10224 rotates around the base 101 and an axis through which the second swing arm 10221 rotates around the base 101 are both parallel to a length direction of the base 101 and do not coincide with each other. In addition, in the embodiment shown in FIG. 4, the second support arm 10224 may be rotatably connected to the base 101 by using a pin shaft, to improve reliability of the rotatable connection between the second support arm 10224 and the base 101.

In addition, the second support arm 10224 is slidingly connected to the second housing fastening bracket 10223. Specifically, as shown in FIG. 7, the second housing fastening bracket 10223 is provided with a second sliding slot 102232, the second support arm 10224 is accommodated in the second sliding slot 102232, and the second support arm 10224 is capable of sliding in the second sliding slot 102232 in the second direction. In this application, to improve reliability of the slidable connection between the second support arm 10224 and the second housing fastening bracket 10223, a second sliding rail may be disposed in the second sliding slot 102232, and a second sliding block may be disposed on the second support arm 10224. In this way, the second sliding block may be clamped on the second sliding rail, so that the second sliding rail may guide sliding of the second support arm 10224 along the second housing fastening bracket 10223 while the second support arm 10224 is limited to the second housing fastening bracket 10223.

It can be learned from the foregoing description that, an axis through which the first support arm 10214 rotates around the base 101 and an axis through which the first swing arm 10211 rotates around the base 101 are parallel to each other, but do not coincide with each other, and an axis through which the second support arm 10224 rotates around the base 101 and an axis through which the second swing arm 10221 rotates around the base 101 are parallel to each other, but do not coincide with each other. Therefore, a phase difference exists in a process in which the first swing arm 10211 and the first support arm 10214 rotate relative to the base 101, and a phase difference exists in a process in which the second swing arm 10221 and the second support arm 10224 rotate relative to the base 101. In this way, in a process of folding and unfolding the electronic device, the first support arm 10214 and the first housing fastening bracket 10213 may slide relative to each other, and the second support arm 10224 and the second housing fastening bracket 10223 may slide relative to each other, so that the first housing fastening bracket 10213 and the second housing fastening bracket 10223 can move in a direction toward or away from the base 101. Therefore, in a process in which the first rotating assembly 1021 and the second rotating assembly 1022 rotate toward each other, the first housing fastening bracket 10213 slides in a direction away from a rotation axis center (the base 101) of the first support arm 10214 relative to the first support arm 10214, and the second housing fastening bracket 10223 slides in a direction away from a rotation axis center (the base 101) of the second support arm 10224 relative to the second support arm 10224. In this way, extension lengths of the first rotating assembly 1021 and the second rotating assembly 1022 relative to the base 101 are increased, and screen accommodating space that meets a bending requirement of a foldable part of the flexible display may be formed between the first rotating assembly 1021, the second rotating assembly 1022, and the base 101. In addition, in a process in which the first rotating assembly 1021 and the second rotating assembly 1022 rotate away from each other, the first housing fastening bracket 10213 slides in a direction close to the rotation axis center of the first support arm 10214 relative to the first support arm 10214, and the second housing fastening bracket 10223 slides in a direction close to the rotation axis center of the second support arm 10224 relative to the second support arm 10224, so that extension lengths of the first rotating assembly 1021 and the second rotating assembly 1022 relative to the base 101 are reduced, and a length of the hinge mechanism is reduced. In this way, when the hinge mechanism is in a closed state, an unfolded state, or a folding process, extension lengths of the first rotating assembly 1021 and the second rotating assembly 1022 relative to the base 101 can adapt to a state of the flexible display, to avoid pulling or squeezing on the flexible display 4. This helps improve structural reliability of the flexible display 4, to reduce a risk of damage to the flexible display 4.

In this embodiment of this application, the first swing arm 10211 is rotatably connected to the base 101, and the first swing arm 10211 is connected to the first housing fastening bracket 10213 by using the first radial rotating arm 10212. In this case, when the electronic device is in an unfolded state, to avoid interference between the first radial rotating arm 10212 and the base 101, an avoidance design may be provided for the first radial rotating arm 10212. During specific implementation, refer to FIG. 8. FIG. 8 is a diagram of a structure of the first radial rotating arm 10212 when an electronic device is in an unfolded state according to an embodiment of this application. The first radial rotating arm 10212 further includes a first avoidance opening 102123, and the first avoidance opening 102123 is located between the first connection part 102121 and the second connection part 102122.

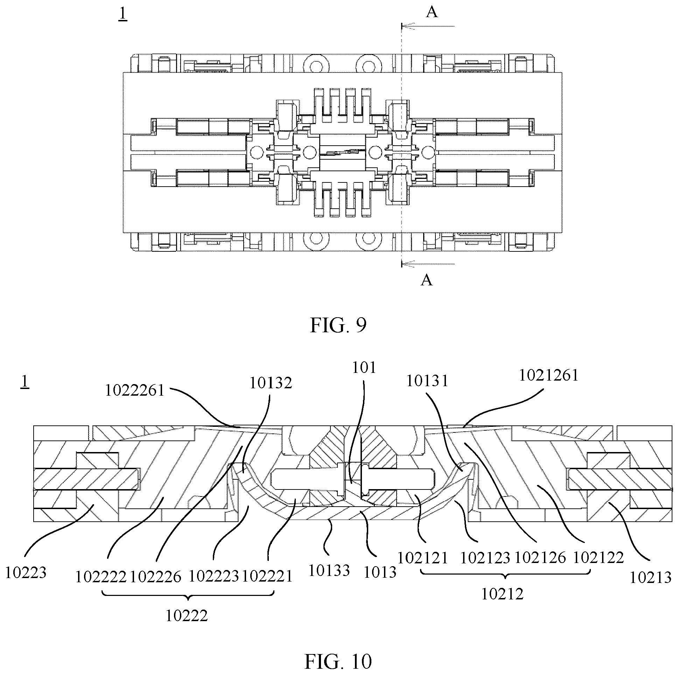

In addition, refer to FIG. 9 and FIG. 10. FIG. 9 is a top view of the hinge mechanism 1 when an electronic device is in an unfolded state according to an embodiment of this application, and FIG. 10 is a sectional view at A-A of the hinge mechanism 1 shown in FIG. 9. It can be learned from FIG. 10 that the base 101 further includes an appearance housing 1013, and the appearance housing 1013 is disposed away from the flexible display. In addition, the appearance housing 1013 includes a first end 10131 and a second end 10132. The first end 10131 is disposed facing the first housing fastening bracket 10213, and the second end 10132 is disposed facing the second housing fastening bracket 10223. In this application, the appearance housing 1013 may further include an appearance surface 10133. The appearance surface 10133 is disposed away from the flexible display, and in a rotation process of the hinge mechanism 1, the appearance surface 10133 is always located outside the hinge mechanism 1.

Still refer to FIG. 10. When the electronic device is in an unfolded state, the first end 10131 of the appearance housing 1013 may be inserted into the first avoidance opening 102123. It may be understood that an opening shape of the first avoidance opening 102123 may be set based on a shape of the first end 10131 of the appearance housing 1013, so that the hinge mechanism 1 may further have a complete appearance surface when the first radial rotating arm 10212 avoids the first end 10131 of the appearance housing 1013. This helps improve appearance aesthetics of the electronic device.

Still refer to FIG. 10. The second radial rotating arm 10222 further includes a second avoidance opening 102223, and the second avoidance opening 102223 is located between the third connection part 102221 and the fourth connection part 102222. In addition, the second end 10132 of the appearance housing 1013 may be inserted into the second avoidance opening 102223. In this case, an opening shape of the second avoidance opening 102223 may be set based on a shape of the second end 10132 of the appearance housing 1013, so that the hinge mechanism 1 may further have a complete appearance surface when the second radial rotating arm 10222 avoids the second end 10132 of the appearance housing 1013. This helps improve appearance aesthetics of the electronic device.

It should be noted that, in this application, the first avoidance opening 102123 is provided on the first radial rotating arm 10212, and the second avoidance opening 102223 is provided on the second radial rotating arm 10222, so that interference between the first radial rotating arm 10212 and the second radial rotating arm 10222 and the appearance housing 1013 of the base 101 can be avoided, a wall thickness of a part that is of the first radial rotating arm 10212 and that is disposed away from the first avoidance opening 102123 may further increase in a direction away from the first avoidance opening 102123, and a wall thickness of a part that is of the second radial rotating arm 10222 and that is disposed away from the second avoidance opening 102223 may further increase in a direction away from the second avoidance opening 102223. In this way, structural reliability of the first radial rotating arm 10212 and the second radial rotating arm 10222 may be increased, so that structural strength of the first radial rotating arm 10212 and the second radial rotating arm 10222 meets a requirement. This helps improve structural reliability of the hinge mechanism 1.

During specific implementation, still refer to FIG. 10. The first radial rotating arm 10212 may further include a first avoidance part 102126, the first avoidance part 102126 is located between the first connection part 102121 and the second connection part 102122, and the first connection part 102121 and the second connection part 102122 are connected by using the first avoidance part 102126. The first avoidance part 102126 and the first avoidance opening 102123 are disposed away from each other. In this application, a surface that is of the first avoidance part 102126 and that is away from the first avoidance opening 102123 may be defined as a first connection surface 1021261. Similarly, the second radial rotating arm 10222 may further include a second avoidance part 102226, where the second avoidance part 102226 is located between the third connection part 102221 and the fourth connection part 102222, and the third connection part 102221 and the fourth connection part 102222 are connected by using the second avoidance part 102226. The second avoidance part 102226 and the second avoidance opening 102223 are disposed away from each other. In this application, a surface that is of the second avoidance part 102226 and that is away from the second avoidance opening 102223 may be defined as a second connection surface 1022261.

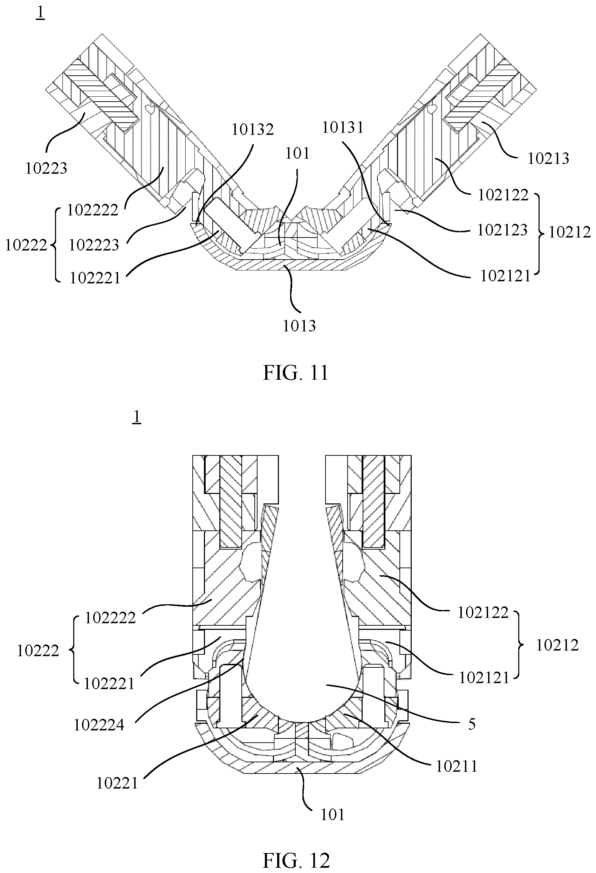

FIG. 11 is a diagram of a structure of the hinge mechanism 1 shown in FIG. 10 when an electronic device is in an intermediate state. The intermediate state of the electronic device is any state in a process of changing from an unfolded state to a closed state, or from a closed state to an unfolded state. It can be learned by comparing FIG. 10 with FIG. 11 that, in a process of changing the electronic device from the unfolded state shown in FIG. 10 to the intermediate state shown in FIG. 11, the first end 10131 of the appearance housing 1013 may slide out from the first avoidance opening 102123 of the first radial rotating arm 10212, and the second end 10132 of the appearance housing 1013 may slide out from the second avoidance opening 102223 of the second radial rotating arm 10222. In this process, interference between the first radial rotating arm 10212 and the second radial rotating arm 10222 and the appearance housing 1013 of the base 101 may also be avoided.

In addition, FIG. 12 is a diagram of a structure of the hinge mechanism 1 shown in FIG. 10 when an electronic device is in a closed state. It can be learned by comparing FIG. 10 with FIG. 12 that, in a process in which the electronic device changes from an unfolded state to the closed state, a relative position relationship between the first avoidance opening 102123 of the first radial rotating arm 10212 and the first housing fastening bracket 10213 changes, and a relative position relationship between the second avoidance opening 102223 of the second radial rotating arm 10222 and the second housing fastening bracket 10223 changes. In this process, the first radial rotating arm 10212 rotates relative to the first housing fastening bracket 10213, and the second radial rotating arm 10222 rotates relative to the second housing fastening bracket 10223. In addition, in this process, each of the first connection surface 1021261 of the first radial rotating arm 10212 and the second connection surface 1022261 of the second radial rotating arm 10222 rotates toward a side away from the flexible display.

It can be understood from the foregoing analysis of FIG. 10 to FIG. 12 that, in the hinge mechanism provided in this application, in a process in which the electronic device changes from the unfolded state to the closed state, the first support arm 10214 may rotate around the base to drive the first radial rotating arm 10212 to rotate around an axis of first radial rotating arm 10212 relative to the first swing arm 10211 and the first housing fastening bracket 10213, and the second support arm 10224 may rotate around the base to drive the second radial rotating arm 10222 to rotate around an axis of the second radial rotating arm 10222 relative to second swing arm 10221 and the second housing fastening bracket 10223, so that each of the first connection surface of the first radial rotating arm 10212 and the second connection surface of the second radial rotating arm 10222 rotates toward a side away from the flexible display. Such a structure design enables a thickness of the first avoidance part 102126 of the first radial rotating arm 10212 and a thickness of the second avoidance part 102226 of the second radial rotating arm 10222 to be flexibly set or even increased according to a strength requirement. In addition, because the first avoidance part 102126 and the second avoidance part 102226 rotate in a direction away from the flexible display in a folding process of the electronic device, interference caused by the first avoidance part 102126 and the second avoidance part 102226 to the flexible display can be effectively avoided when the electronic device is in the closed state. Therefore, according to the hinge mechanism provided in this application, when the first radial rotating arm 10212 and the second radial rotating arm 10222 avoid the appearance housing and the flexible display, structural strength of the entire first radial rotating arm 10212 and the second radial rotating arm 10222 can be further ensured. This can help improve structural reliability of the hinge mechanism.

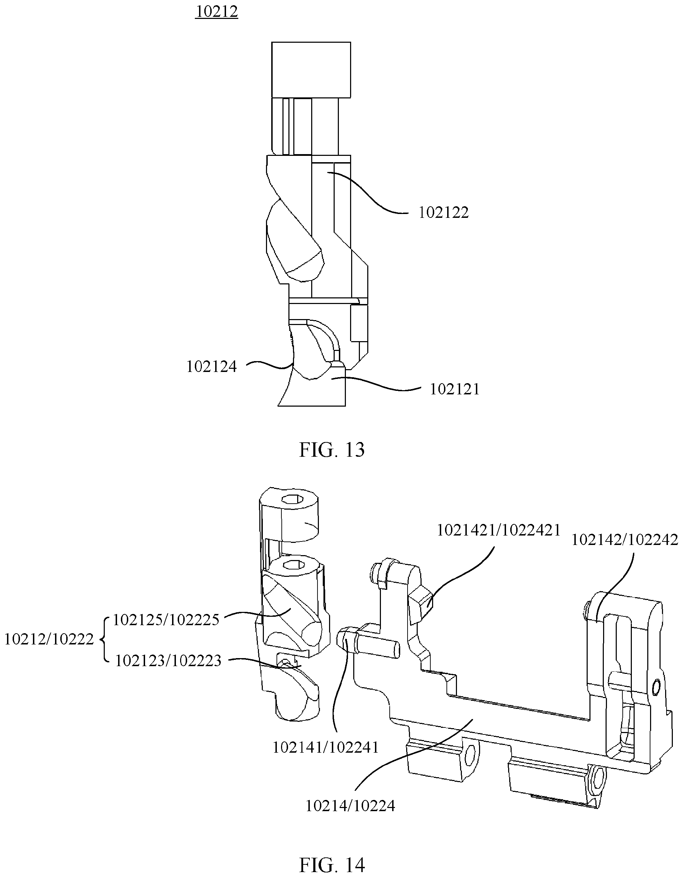

FIG. 13 is a diagram of a structure of the first radial rotating arm 10212 of the hinge mechanism 1 shown in FIG. 12, and is used to display a state of the first radial rotating arm 10212 when the electronic device is in a closed state. In this application, when the electronic device is in the closed state, to enable the hinge mechanism 1 to form screen accommodating space that meets a bending requirement of the flexible display 4, the first radial rotating arm 10212 may be further provided with a first avoidance surface 102124. In addition, when the electronic device is in the closed state, the first avoidance surface 102124 is disposed facing a folding inner side of the hinge mechanism 1, so that the first avoidance surface 102124 avoids a foldable part of the flexible display. Refer to FIG. 12 and FIG. 13 together. The first avoidance surface 102124 may be disposed on the first connection part 102121, and the first avoidance surface 102124 may be an arc-shaped concave surface. In this application, a specific shape of the first avoidance surface 102124 is not limited, and may be specifically set based on a bending form of the foldable part of the flexible display 4.

When the electronic device is in the closed state, to enable the hinge mechanism 1 to form screen accommodating space 5 for accommodating the foldable part of the flexible display 4 as symmetrical space, as shown in FIG. 12, a second avoidance surface 102224 may be further disposed on the second radial rotating arm 10222, the second avoidance surface 102224 may be disposed on the third connection part 102221, and the second avoidance surface 102224 may be an arc-shaped concave surface. In addition, the second avoidance surface 102224 is disposed facing a folding inner side of the hinge mechanism 1. When the electronic device is in the closed state, the first avoidance surface 102124 and the second avoidance surface 102224 may be disposed opposite to each other, and the first avoidance surface 102124 and the second avoidance surface 102224 may avoid the foldable part of the flexible display 4. This can help improve force-bearing uniformity of the flexible display 4, thereby improving structural reliability of the flexible display 4.

Still refer to FIG. 12. In this embodiment of this application, when the electronic device is in the closed state, a surface that is of the first swing arm 10211 and that faces the folding inner side of the hinge mechanism 1 may also be an arc-shaped concave surface, and the arc-shaped concave surface of the first swing arm 10211 may be connected to the first avoidance surface 102124 to form a smooth avoidance surface. A surface that is of the second swing arm 10221 and that faces the folding inner side of the hinge mechanism 1 may also be an arc-shaped concave surface, and the arc-shaped concave surface of the second swing arm 10221 may be connected to the second avoidance surface 102224 to form a smooth avoidance surface. Therefore, when the electronic device is in the closed state, screen accommodating space formed by the hinge mechanism 1 is increased, and a risk of squeezing caused to the foldable part of the flexible display 4 can be reduced.

In the hinge mechanism provided in this application, the first avoidance opening 102123, the first connection surface 1021261, and the first avoidance surface 102124 are respectively disposed in three different directions, and the second avoidance opening 102223, the second connection surface 1022261, and the second avoidance surface 102224 are respectively disposed in three different directions, so that when the electronic device is in an unfolded state, the first avoidance opening 102123 and the second avoidance opening 102223 may avoid the appearance housing. However, in a process of folding the electronic device from an unfolded state to the closed state, the first connection surface 1021261 and the second connection surface 1022261 may rotate in a direction away from the flexible display, to prevent the first avoidance part 102126 and the second avoidance part 102226 from causing interference to the flexible display. In addition, when the electronic device is in the closed state, the first avoidance surface 102124 and the second avoidance surface 102224 may face the foldable part of the flexible display, to avoid the foldable part of the flexible display. In this design, the hinge mechanism can avoid the appearance housing and the flexible display, and structural strength of the hinge mechanism can be ensured while a size of the hinge mechanism is not increased, so that the hinge mechanism is light, thin, and reliable.

It can be learned from the foregoing description that, because a phase difference exists between the first support arm 10214 and the first swing arm 10211, and a phase difference exists between the second support arm 10224 and the second swing arm 10221, in a folding process of the electronic device, the first support arm 10214 may slide relative to the first housing fastening bracket 10213, and the second support arm 10224 may slide relative to the second housing fastening bracket 10223. In addition, in a first direction, relative positions of the first swing arm 10211, the first radial rotating arm 10212, and the first housing fastening bracket 10213 are fixed, and therefore, the first support arm 10214 moves relative to the first radial rotating arm 10212 while sliding relative to the first housing fastening bracket 10213. Similarly, in a second direction, relative positions of the second swing arm 10221, the second radial rotating arm 10222, and the second housing fastening bracket 10223 are fixed, and therefore, the second support arm 10224 moves relative to the second radial rotating arm 10222 while sliding relative to the second housing fastening bracket 10223. Based on this, in this embodiment of this application, the first support arm 10214 may slide relative to the first housing fastening bracket 10213 to drive the first radial rotating arm 10212 to rotate relative to the first swing arm 10211 and the first housing fastening bracket 10213. In addition, the second support arm 10224 slides relative to the second housing fastening bracket 10223 to drive the second radial rotating arm 10222 to rotate relative to the second swing arm 10221 and the second housing fastening bracket 10223.

During specific implementation, refer to FIG. 14. FIG. 14 is a diagram of a cooperation relationship between the first radial rotating arm 10212 and the first support arm 10214 according to an embodiment of this application. The first radial rotating arm 10212 is provided with a first track slot 102125, the first support arm 10214 is provided with a first guide part 102141, and the first guide part 102141 may be inserted into the first track slot 102125. In this case, in a process in which the first support arm 10214 slides along the first housing fastening bracket 10213, the first guide part 102141 may slide along the first track slot 102125.

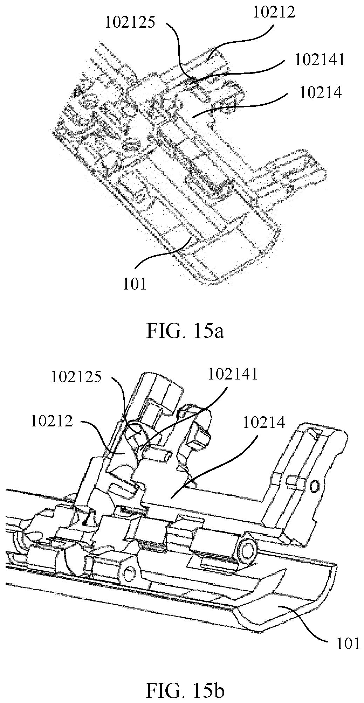

FIG. 15a is a diagram of a partial structure of the hinge mechanism 1 according to an embodiment of this application. The hinge mechanism 1 may be configured to display a relative position relationship between the first support arm 10214, the first radial rotating arm 10212, and the base 101 when an electronic device is in an unfolded state. In this case, as shown in FIG. 10, the first avoidance opening 102123 of the first radial rotating arm 10212 avoids the first end 10131 of the appearance housing 1013 of the base 101.

FIG. 15b is another diagram of a partial structure of the hinge mechanism 1 according to an embodiment of this application. The hinge mechanism 1 may be configured to display a relative position relationship between the first support arm 10214, the first radial rotating arm 10212, and the base 101 when an electronic device is in an intermediate state. Refer to FIG. 15a and FIG. 15b together. It can be learned that, in a process in which the electronic device changes from an unfolded state to a closed state, the first guide part 102141 of the first support arm 10214 slides toward the base 101 relative to the first track slot 102125, to drive the first radial rotating arm 10212 to rotate at a specified angle relative to the first swing arm 10211 and the first housing fastening bracket 10213.

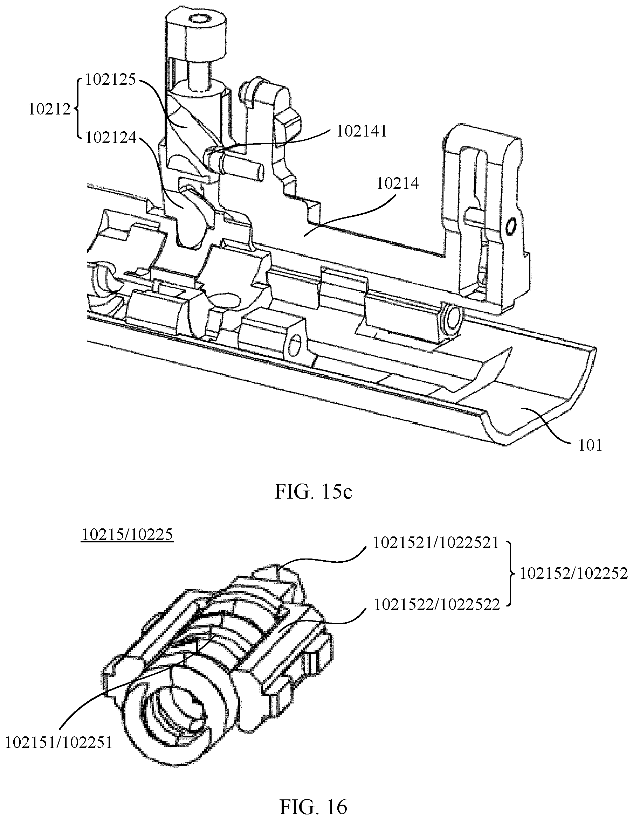

In addition, FIG. 15c is another diagram of a partial structure of the hinge mechanism 1 according to an embodiment of this application. The hinge mechanism 1 may be configured to display a relative position relationship between the first support arm 10214, the first radial rotating arm 10212, and the base 101 when an electronic device is in a closed state. In this case, the first avoidance surface 102124 of the first radial rotating arm 10212 faces a folding inner side of the hinge mechanism 1, so that the first radial rotating arm 10212 can avoid the foldable part of the flexible display, and can avoid squeezing on the foldable part of the flexible display 4.

It may be understood that, in this application, a form of the first track slot 102125 may be fitted based on a trajectory of rotation of the first swing arm 10211 and the first support arm 10214 around the base 101, a phase difference in a rotation process of the first swing arm 10211 and the first support arm 10214, and the like. For example, the first track slot 102125 is a spiral slot. In this way, the first guide part 102141 may slide along the first track slot 102125 to drive the first radial rotating arm 10212 to rotate relative to the first swing arm 10211, so that when the electronic device is in an unfolded state, the first end 10131 of the appearance housing 1013 is inserted into the first avoidance opening 102123; and when the electronic device is in the closed state, the first avoidance surface 102124 of the first radial rotating arm 10212 may avoid a foldable part of the flexible display.

In this embodiment of this application, a cooperation relationship between the second radial rotating arm 10222 and the second support arm 10224 is similar to a cooperation relationship between the first radial rotating arm 10212 and the first support arm 10214. Specifically, still refer to FIG. 14. FIG. 14 may be used to show the cooperation relationship between the second radial rotating arm 10222 and the second support arm 10224. The second radial rotating arm 10222 is provided with a second track slot 102225, the second support arm 10224 is provided with a second guide part 102241, and the second guide part 102241 may be inserted into the second track slot 102225. In this case, in a process in which the second support arm 10224 slides along the second housing fastening bracket 10223, the second guide part 102241 may slide along the second track slot 102225.

In addition, in this application, a form of the second track slot 102225 may be fitted based on a trajectory of rotation of the second swing arm 10221 and the second support arm 10224 around the base 101, a phase difference in a rotation process of the second swing arm 10221 and the second support arm 10224, and the like. For example, the second track slot 102225 is a spiral slot. In this way, the second guide part 102241 may slide along the second track slot 102225 to drive the second radial rotating arm 10222 to rotate relative to the second swing arm 10221, so that when the electronic device is in the unfolded state, the second end 10132 of the appearance housing 1013 is inserted into the second avoidance opening 102223 of the second radial rotating arm 10222. In this way, the second radial rotating arm 10222 avoids the base 101. In a process in which the electronic device changes from the unfolded state to the closed state, the second guide part 102241 of the second support arm 10224 slides toward the base 101 relative to the second track slot 102225, to drive the second radial rotating arm 10222 to rotate at a specified angle relative to the second swing arm 10221 and the second housing fastening bracket 10223. When the electronic device is in the closed state, the second avoidance surface 102224 of the second radial rotating arm 10222 may avoid a foldable part of the flexible display, so that the second radial rotating arm 10222 releases the screen accommodating space 5, and can avoid squeezing on the foldable part of the flexible display.

It may be understood that, in a process in which the electronic device changes from the closed state to the unfolded state, a movement direction of each structure is opposite to a movement direction in the foregoing process in which the electronic device changes from the unfolded state to the closed state. Details are not described herein again.

Still refer to FIG. 4. In this application, the first rotating assembly 1021 may further include a first damping module 10215. In addition, refer to FIG. 7. The first housing fastening bracket 10213 further includes a first mounting slot 102133, the first damping module 10215 is mounted in the first mounting slot 102133, and a first notch 1021331 is provided on a slot wall of the first mounting slot 102133. In addition, the first mounting slot 102133 may be adjacent to the first sliding slot 102132. In this case, the first sliding slot 102132 may communicate with the first mounting slot 102133 through the first notch 1021331.

When the first damping module 10215 is specifically disposed, refer to FIG. 16. FIG. 16 is a diagram of a structure of the first damping module 10215 according to an embodiment of this application. The first damping module 10215 may include a first elastic member 102151 and a first damping bracket 102152. The first elastic member 102151 may be but is not limited to a spring, and the first damping bracket 102152 includes a first protrusion 1021521. Refer to FIG. 7 and FIG. 16 together. The first elastic member 102151 may press the first damping bracket 102152 toward a slot wall of the first mounting slot 102133. In addition, under an action of elastic force of the first elastic member 102151, the first protrusion 1021521 of the first damping bracket 102152 may slide along the first notch 1021331 and extend into the first sliding slot 102132.

It may be understood that, in this application, when the first elastic member 102151 is a spring, as shown in FIG. 7, a first limiting post 1021332 may be further disposed in the first mounting slot 102133. In this case, the spring may be sleeved on the first limiting post 1021332, and may effectively prevent the first elastic member 102151 from being bent in a process in which the first elastic member 102151 squeezes the first damping bracket 102152, and therefore, structural reliability of the first damping module 10215 can be effectively improved. In addition, the first damping bracket 102152 may further include two first limiting parts 1021522. An extension direction of the two first limiting parts 1021522 is the same as an action direction of elastic force of the first elastic member 102151. The first elastic member 102151 may be located between the two first limiting parts 1021522, so that a risk of bending the first elastic member 102151 is further reduced under an action of the two first limiting parts 1021522. Therefore, structural reliability of the first damping module 10215 is improved.

It can be learned from the foregoing that the first support arm 10214 may slide along the first sliding slot 102132. In this application, refer to FIG. 7 and FIG. 14 together. A second protrusion 1021421 may be disposed on a surface that is of the first support arm 10214 and that faces the first mounting slot 102133. In this way, when the first protrusion 1021521 extends into the first sliding slot 102132, opposite side surfaces of the first protrusion 1021521 and the second protrusion 1021421 abut against each other in a first direction. In this case, damping force is generated between the first protrusion 1021521 and the second protrusion 1021421, so that the first protrusion 1021521 blocks the first support arm 10214 from continuing to slide along the first sliding slot 102132. Therefore, the first housing fastening bracket 10213 may be kept at a corresponding rotation position. In addition, in a process in which the first rotating assembly 1021 rotates relative to the base 101, because of existence of damping force between the first support arm 10214 and the first damping module 10215, a user may have an obvious hand feeling of a jerk in a process of unfolding and closing the electronic device, to improve user experience.

It may be understood that, because the first protrusion 1021521 may always abut against two slopes of the second protrusion 1021421 and a connection surface located between the two slopes, a manner in which the two slopes of the second protrusion 1021421 abut against the connection surface located between the two slopes, and a manner in which the first protrusion 1021521 abuts against the second protrusion 1021421 are properly designed, so that when the electronic device is in the unfolded state and the closed state, the first housing fastening bracket 10213 is kept at corresponding rotation positions. In addition, in a process in which the electronic device changes from an intermediate state to the unfolded state or the closed state, abutting force between the first protrusion 1021521 and the second protrusion 1021421 may be small. Therefore, without an action of external force, the second protrusion 1021421 may continue to slide in a first direction relative to the first protrusion 1021521 until the electronic device is in a stable unfolded state or closed state. In this way, a self-unfolding function of the electronic device in an end phase of the unfolded state and a self-closing function of the electronic device in an end phase of the closed state can be implemented.

Still refer to FIG. 4. In this application, the first support arm 10214 may include two first connection arms 102142 that are disposed opposite to each other. In this case, one first sliding slot 102132 may be provided on the first housing fastening bracket 10213 corresponding to each first connection arm 102142, so that each first connection arm 102142 may slide in the corresponding first sliding slot 102132 to implement a slidable connection between the first support arm 10214 and the first housing fastening bracket 10213. In addition, along an extension direction of a rotation axis of the first support arm 10214, the two first connection arms 102142 are disposed at an interval. In this case, the first mounting slot 102133 and the first damping module 10215 are located between the two first connection arms 102142. In this way, a structure of the first rotating assembly 1021 may be compact, thereby facilitating implementation of a miniaturization design of the hinge mechanism 1.

It should be noted that when the first support arm 10214 includes two first connection arms 102142 that are disposed opposite to each other, the second protrusion 1021421 may be disposed on a surface that is of one of the first connection arms 102142 and that faces the first mounting slot 102133, or one second protrusion 1021421 may be disposed on a surface that is of each first connection arm 102142 and that faces the first mounting slot 102133. Specifically, adaptive adjustment may be performed based on a quantity and disposing positions of first protrusions 1021521 and first notches 1021331.

In this application, the second rotating assembly 1022 further includes a second damping module 10225. The second damping module 10225 may be disposed with reference to the first damping module 10215. For example, FIG. 7 may also be used to show a structure of the second housing fastening bracket 10223. The second housing fastening bracket 10223 further includes a second mounting slot 102233, the second damping module 10225 is mounted in the second mounting slot 102233, and a second notch 1022331 is provided on a slot wall of the second mounting slot 102233. In addition, the second mounting slot 102233 may be adjacent to the second sliding slot 102232. In this case, the second sliding slot 102232 may communicate with the second mounting slot 102233 through the second notch 1022331.

When the second damping module 10225 is specifically disposed, refer to FIG. 16. FIG. 16 may also be used to show a structure of the second damping module 10225. The second damping module 10225 may include a second elastic member 102251 and a second damping bracket 102252. The second elastic member 102251 may be but is not limited to a spring, and the second damping bracket 102252 includes a third protrusion 1022521. In this case, the second elastic member 102251 may press the second damping bracket 102252 toward a slot wall of the second mounting slot 102233. In addition, under an action of elastic force of the second elastic member 102251, the third protrusion 1022521 of the second damping bracket 102252 may slide along the second notch 1022331 and extend into the second sliding slot 102232.

In this application, when the second elastic member 102251 is a spring, a second limiting post 1022332 may be further disposed in the second mounting slot 102233. In this case, the spring may be sleeved on the second limiting post 1022332, and may effectively prevent the second elastic member 102251 from being bent in a process in which the second elastic member squeezes the second damping bracket, and therefore, structural reliability of the second damping module 10225 can be effectively improved. In addition, the second damping bracket 102252 may further include two second limiting parts 1022522. An extension direction of the two second limiting parts 1022522 is the same as an action direction of elastic force of the second elastic member 102251. The second elastic member 102251 may be located between the two second limiting parts 1022522, so that a risk of bending the second elastic member 102251 is further reduced under an action of the two second limiting parts 1022522. Therefore, structural reliability of the second damping module 10225 is improved.

It can be learned from the foregoing that the second support arm 10224 may slide along the second sliding slot 102232. In this application, refer to FIG. 7 and FIG. 14 together. A fourth protrusion 1022421 may be disposed on a surface that is of the second support arm 10224 and that faces the second mounting slot 102233. In this way, when the third protrusion 1022521 extends into the second sliding slot 102232, opposite side surfaces of the third protrusion 1022521 and the fourth protrusion 1022421 abut against each other in a second direction. In this case, damping force is generated between the third protrusion 1022521 and the fourth protrusion 1022421, so that the third protrusion 1022521 blocks the second support arm 10224 from continuing to slide along the second sliding slot 102232. Therefore, the second housing fastening bracket 10223 may be kept at a corresponding rotation position. In addition, in a process in which the second rotating assembly 1022 rotates relative to the base 101, because of existence of damping force between the second support arm 10224 and the second damping module 10225, a user may have an obvious hand feeling of a jerk in a process of unfolding and closing the electronic device, so that user experience is improved.

It may be understood that, because the third protrusion 1022521 may always abut against two slopes of the fourth protrusion 1022421 and a connection surface located between the two slopes, a manner in which the two slopes of the fourth protrusion 1022421 abut against the connection surface located between the two slopes, and a manner in which the third protrusion 1022521 abuts against the fourth protrusion 1022421 are properly designed, so that when the electronic device is in the unfolded state and the closed state, the second housing fastening bracket 10223 is kept at corresponding rotation positions. In addition, in a process in which the electronic device changes from an intermediate state to the unfolded state or the closed state, abutting force between the third protrusion 1022521 and the fourth protrusion 1022421 may be small. Therefore, without an action of external force, the fourth protrusion 1022421 may continue to slide in a second direction relative to the third protrusion 1022521 until the electronic device is in a stable unfolded state or closed state. In this way, a self-unfolding function of the electronic device in an end phase of the unfolded state and a self-closing function of the electronic device in an end phase of the closed state can be implemented.

Still refer to FIG. 14. In this application, the second support arm 10224 may include two second connection arms 102242 that are disposed opposite to each other. In this case, one second sliding slot 102232 may be provided on the second housing fastening bracket 10223 shown in FIG. 7 corresponding to each second connection arm 102242, so that each second connection arm 102242 may slide in the corresponding second sliding slot 102232 to implement a slidable connection between the second support arm 10224 and the second housing fastening bracket 10223. In addition, along an extension direction of a rotation axis of the second support arm 10224, the two second connection arms 102242 are disposed at an interval. In this case, the second mounting slot 102233 and the second damping module 10225 are located between the two second connection arms 102242. In this way, a structure of the second rotating assembly 1022 may be compact, thereby facilitating implementation of a miniaturization design of the hinge mechanism 1.

It should be noted that when the second support arm 10224 includes two second connection arms 102242 that are disposed opposite to each other, the fourth protrusion 1022421 may be disposed on a surface that is of one of the second connection arms 102242 and that faces the second mounting slot 102233, or one fourth protrusion 1022421 may be disposed on a surface that is of each second connection arm 102242 and that faces the second mounting slot 102233. Specifically, adaptive adjustment may be performed based on a quantity and disposing positions of third protrusions 1022521 and second notches 1022331.

Still refer to FIG. 4. In this embodiment of this application, the first rotating assembly 1021 may further include a first support plate 10216. In addition, the second rotating assembly 1022 may further include a second support plate 10226. The first support plate 10216 includes a first plate surface 102161 and a second plate surface 102162 that are disposed back to back. The second support plate 10226 includes a third plate surface 102261 and a fourth plate surface 102262 that are disposed back to back. The first plate surface 102161 may be configured to support the flexible display, and the third plate surface 102261 may be configured to support the flexible display.

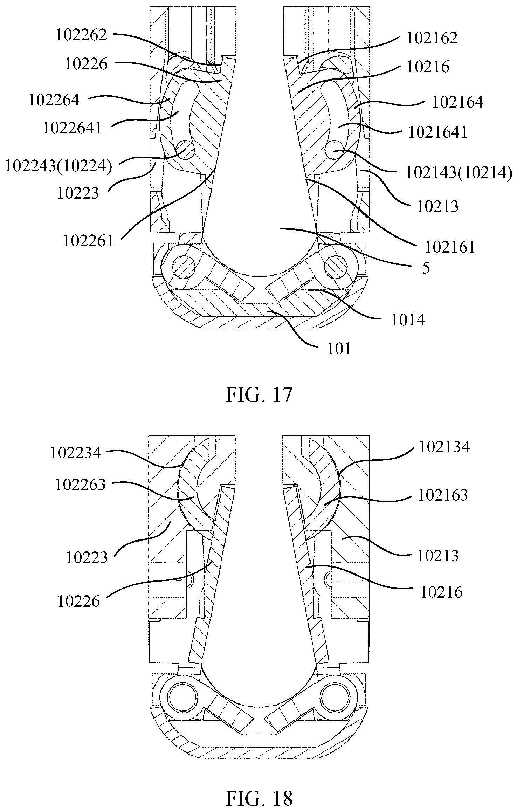

FIG. 17 is another sectional view of the hinge mechanism 1 when an electronic device is in a closed state according to an embodiment of this application. It can be learned from FIG. 17 that, in the hinge mechanism 1 provided in this application, the base 101 may include a bearing surface 1014 configured to support the flexible display. In addition, in the closed state shown in FIG. 17, triangular screen accommodating space 5 may be formed between the first plate surface 102161, the second plate surface 102162, and the bearing surface 1014. A bendable part of the flexible display of the electronic device may be accommodated in the screen accommodating space 5, to form a water droplet-like form.

To enable the hinge mechanism 1 to form the screen accommodating space 5 shown in FIG. 17, in this application, the first support plate 10216 is rotatably connected to the first housing fastening bracket 10213, and the second support plate 10226 is rotatably connected to the second housing fastening bracket 10223. During specific implementation, as shown in FIG. 7, the first housing fastening bracket 10213 may further be provided with a first rotating groove 102134, and the first rotating groove 102134 may be a circular arc-shaped groove. In addition, FIG. 18 is another sectional view of the hinge mechanism 1 when an electronic device is in a closed state according to an embodiment of this application. The sectional view may be used to show a cooperation relationship between the first support plate 10216 and the first housing fastening bracket 10213. An end part that is of the first support plate 10216 and that faces the first housing fastening bracket 10213 may be provided with a first rotating part 102163, and the first rotating part 102163 may be disposed as an arc-shaped rotating part, for example, a circular arc-shaped rotating part. In this case, the first rotating part 102163 may be mounted in the first rotating groove 102134, and the first rotating part 102163 may slide along a groove surface of the first rotating groove 102134 to implement relative rotation between the first support plate 10216 and the first housing fastening bracket 10213.

It may be understood that, to improve stability of rotation of the first support plate 10216 around the first housing fastening bracket 10213, the first housing fastening bracket 10213 may be provided with a plurality of first rotating grooves 102134, and a plurality of first rotating parts 102163 may be disposed on the first support plate 10216. In this way, the first rotating parts 102163 may be mounted in the first rotating grooves 102134 in a one-to-one correspondence. Each first rotating part 102163 slides around a groove surface of the corresponding first rotating groove 102134 to implement a relative rotation between the first support plate 10216 and the first housing fastening bracket 10213.

Similarly, when the second support plate 10226 is rotatably connected to the second housing fastening bracket 10223 specifically, still refer to FIG. 18. The second housing fastening bracket 10223 may be further provided with a second rotating groove 102234, where the second rotating groove 102234 may be a circular arc-shaped groove. In addition, an end part that is of the second support plate 10226 and that faces the second housing fastening bracket 10223 may be provided with a second rotating part 102263, and the second rotating part 102263 may be disposed as an arc-shaped rotating part, for example, a circular arc-shaped rotating part. In this case, the second rotating part 102263 may be mounted in the second rotating groove 102234, and the second rotating part 102263 may slide along a groove surface of the second rotating groove 102234 to implement relative rotation between the second support plate 10226 and the second housing fastening bracket 10223. In addition, the second housing fastening bracket 10223 may be provided with a plurality of second rotating grooves 102234, and the second support plate 10226 is provided with a plurality of second rotating parts 102263. In this way, the second rotating parts 102263 may be mounted in the second rotating grooves 102234 in a one-to-one correspondence, so that each second rotating part 102263 slides around a groove surface of the corresponding second rotating groove 102234 to implement relative rotation between the second support plate 10226 and the second housing fastening bracket 10223. In this way, stability of rotation of the second support plate 10226 around the second housing fastening bracket 10223 is improved.

In this application, a rotatable connection between the first support plate 10216 and the first housing fastening bracket 10213, and a rotatable connection between the second support plate 10226 and the second housing fastening bracket 10223 may be further implemented through another possible manner in addition to the virtual axis. For example, in some other possible embodiments of this application, the first support plate 10216 may alternatively be rotatably connected to the first housing fastening bracket 10213 by using a pin shaft, so that the first support plate 10216 is rotatably connected to the first housing fastening bracket 10213 through a solid axis. Similarly, the second support plate 10226 may alternatively be rotatably connected to the second housing fastening bracket 10223 by using a pin shaft, so that the first support plate 10216 is rotatably connected to the first housing fastening bracket 10213 through a solid axis.

In this application, when the electronic device is in an unfolded state, the first plate surface 102161 of the first support plate 10216, the second plate surface 102162 of the second support plate 10226, and a bearing surface of the base may be located on a same plane, so that the flexible display of the electronic device can be smoothly supported.

It can be learned from the descriptions of the structures of the first rotating assembly 1021 and the second rotating assembly 1022 in the foregoing embodiments that, in the first rotating assembly 1021, the first housing fastening bracket 10213 may drive the first support arm 10214 to rotate around the base 101, and in the second rotating assembly 1022, the second housing fastening bracket 10223 may drive the second support arm 10224 to rotate around the base. Based on this, in this application, it may be considered that the first support arm 10214 rotates around the base 101 to drive the first support plate 10216 to rotate around the first housing fastening bracket 10213. Similarly, the second support arm 10224 may alternatively rotate around the base 101 to drive the second support plate 10226 to rotate around the second housing fastening bracket 10223.

During specific implementation, still refer to FIG. 17. A first guide member 102164 may be disposed on the second plate surface 102162 of the first support plate 10216, and a third track slot 1021641 may be provided on the first guide member 102164. In addition, in this application, the first support arm 10214 may be further provided with a first guide structure 102143. The first guide structure 102143 may be but is not limited to a columnar structure, and the first guide structure 102143 may be inserted into the third track slot 1021641 of the first support plate 10216, and may slide along the third track slot 1021641. In this way, in a process in which the first support arm 10214 rotates around the base 101, the first guide structure 102143 may slide in the third track slot 1021641, to drive the first support plate 10216 to rotate around the first housing fastening bracket 10213.

Similarly, a second guide member 102264 may be disposed on the fourth plate surface 102262 of the second support plate 10226, and a fourth track slot 1022641 may be provided on the second guide member 102264. In addition, in this application, the second support arm 10224 may be further provided with a second guide structure 102243. The second guide structure 102243 may be but is not limited to a columnar structure, and the second guide structure 102243 may be inserted into the fourth track slot 1022641 of the second support plate 10226, and may slide along the fourth track slot 1022641. In this way, in a process in which the second support arm 10224 rotates around the base 101, the second guide structure 102243 may slide in the fourth track slot 1022641, to drive the second support plate 10226 to rotate around the second housing fastening bracket 10223.

In the embodiment shown in FIG. 17, the third track slot 1021641 and the fourth track slot 1022641 may be closed slots, and the first guide structure 102143 and the second guide structure 102243 may be guide shafts. In this way, reliability of motion of the first guide structure 102143 and the second guide structure 102243 in the corresponding track slots can be improved, so that the motion of the first support plate 10216 and the second support plate 10226 is stable.

In this embodiment of this application, in a rotation process of the hinge mechanism 1 from the unfolded state to the closed state of the electronic device, the first housing fastening bracket 10213 and the second housing fastening bracket 10223 rotate toward each other, the first housing fastening bracket 10213 drives the first support arm 10214 to rotate around the base 101, the second housing fastening bracket 10223 drives the second support arm 10224 to rotate around the base 101, and the first guide structure 102143 of the first support arm 10214 slides along the third track slot 1021641, to drive the first support plate 10216 to rotate relative to the first housing fastening bracket 10213, and drive an end that is of the first support plate 10216 and that is close to the base 101 to move in a direction away from the base 101. In addition, the second guide structure 102243 of the second support arm 10224 slides along the fourth track slot 1022641, to drive the second support plate 10226 to rotate relative to the second housing fastening bracket 10223, and drive an end that is of the second support plate 10226 and that is close to the base 101 to move in a direction away from the base 101. Therefore, screen accommodating space 5 for accommodating a bendable part of the flexible display may be formed between the first support plate 10216, the base 101, and the second support plate 10226.

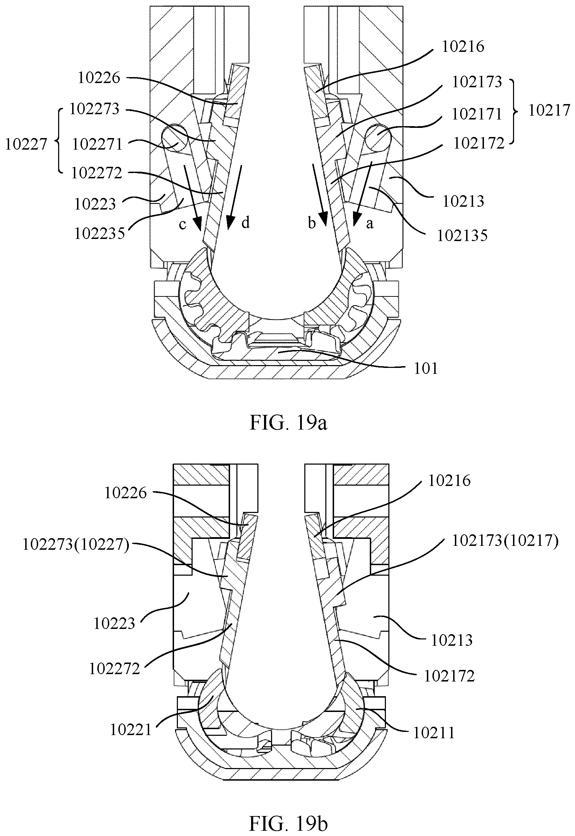

Still refer to FIG. 4. In this application, the first rotating assembly 1021 further includes a third support plate 10217, the third support plate 10217 is slidably connected to the first housing fastening bracket 10213, and the third support plate 10217 is slidably connected to the first support plate 10216. During specific implementation, refer to FIG. 19a. FIG. 19a is another sectional view of the hinge mechanism 1 when an electronic device is in a closed state according to an embodiment of this application. The sectional view may be used to show a cooperation relationship between the third support plate 10217 and the first housing fastening bracket 10213. The third support plate 10217 includes a first sliding part 102171 and a first support part 102172. The first housing fastening bracket 10213 includes a fifth track slot 102135. The first sliding part 102171 is inserted into the fifth track slot 102135, and may slide along the fifth track slot 102135 relative to the first housing fastening bracket 10213. In this application, a specific disposing form of the fifth track slot 102135 is not limited. For example, the fifth track slot 102135 may be a linear slot. The first sliding part 102171 may slide in the fifth track slot 102135 in a third direction relative to the first housing fastening bracket 10213, where the third direction is a direction shown by a in FIG. 19a.

In addition, still refer to FIG. 4. The first support plate 10216 includes a third sliding slot 102165, and the first support part 102172 may slide along the third sliding slot 102165. Specific disposing forms of the third sliding slot 102165 and the first support part 102172 are not limited in this application. For example, the third sliding slot 102165 may be a linear slot. In addition, as shown in FIG. 4, in an axial direction of the hinge mechanism 1, there may be a plurality of third sliding slots 102165 provided in parallel. The first support part 102172 may be disposed as a comb-shaped structure, and each comb of the first support part 102172 is correspondingly inserted into one third sliding slot 102165, and may slide in a fourth direction in the third sliding slot 102165 relative to the first support plate 10216, so that the first support part 102172 slides in the fourth direction in the third sliding slot 102165 relative to the first support plate 10216, where the fourth direction is a direction shown by b in FIG. 19a.

Still refer to FIG. 19a. In this application, when the electronic device is in the closed state, an included angle between the third direction and the fourth direction is greater than 0°, so that the first housing fastening bracket 10213 and the first support plate 10216 limit a motion of the third support plate 10217 toward the base 101. In this way, fall-off of the third support plate 10217 can be avoided.

FIG. 19b is another sectional view of the hinge mechanism 1 when an electronic device is in a closed state according to an embodiment of this application. It can be learned from FIG. 19b that, when the electronic device is in the closed state, the third support plate 10217 may avoid the first swing arm 10211, so that the hinge mechanism 1 may form, in the closed state, screen accommodating space that meets a bending requirement of a flexible display. In addition, refer to FIG. 19a and FIG. 19b together. The third support plate 10217 may further include a first abutting part 102173, where the first abutting part 102173 may be located between the first sliding part 102171 and the first support part 102172. When the electronic device is in the closed state, the first abutting part 102173 abuts against the first housing fastening bracket 10213. In this way, the first housing fastening bracket 10213 provides support force for the first abutting part 102173 in a direction away from the base 101, and the first housing fastening bracket 10213 provides support force for the third support plate 10217 in a direction away from the base 101, to prevent the third support plate 10217 from falling off. This improves structural reliability of the first rotating assembly 1021 and further improves structural reliability of the hinge mechanism 1.

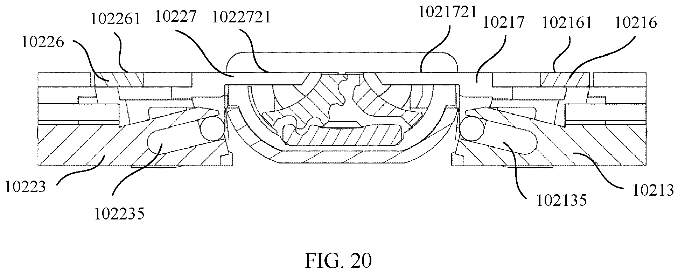

As shown in FIG. 4, in this application, the first support part 102172 includes a fifth plate surface 1021721. In addition, FIG. 20 is a diagram of a structure of the hinge mechanism 1 shown in FIG. 19a when an electronic device is in an unfolded state. In the state shown in FIG. 20, the third support plate 10217 is located on a side that is of the first swing arm 10211 and that faces a flexible display, and the first plate surface 102161 and the fifth plate surface 1021721 are connected to form a support surface for supporting the flexible display. This helps improve integrity of the support surface that is of the hinge mechanism 1 and that is configured to support the flexible display, thereby implementing smoothly supporting the flexible display.

Still refer to FIG. 19a. The second rotating assembly 1022 further includes a fourth support plate 10227. The fourth support plate 10227 is slidingly connected to the second housing fastening bracket 10223, and the fourth support plate 10227 is slidingly connected to the second support plate 10226. During specific implementation, the fourth support plate 10227 includes a second sliding part 102271 and a second support part 102272, the second housing fastening bracket 10223 includes a sixth track slot 102235, and the first sliding part 102171 is inserted into the sixth track slot 102235, and may slide along the sixth track slot 102235 relative to the second housing fastening bracket 10223. In this application, a specific disposing form of the sixth track slot 102235 is not limited. For example, the sixth track slot 102235 may be a linear slot. The second sliding part 102271 may slide in the sixth track slot 102235 in a fifth direction relative to the second housing fastening bracket 10223, where the fifth direction is a direction shown by c in FIG. 19a.

In addition, still refer to FIG. 4. The second support plate 10226 includes a fourth sliding slot 102265, and the second support part 102272 may slide along the fourth sliding slot 102265. Specific disposing forms of the fourth sliding slot 102265 and the second support part 102272 are not limited in this application. For example, the fourth sliding slot 102265 may be a linear slot. In addition, as shown in FIG. 4, in an axial direction of the hinge mechanism 1, there may be a plurality of fourth sliding slots 102265 that are disposed in parallel, and the second support part 102272 may be disposed as a comb-shaped structure. In this case, each comb of the second support part 102272 is correspondingly inserted into one fourth sliding slot 102265. In addition, the second support part 102272 may slide in a sixth direction in the fourth sliding slot 102265 relative to the second support plate 10226, so that the second support part 102272 slides in the sixth direction in the fourth sliding slot 102265 relative to the second support plate 10226, where the sixth direction is a direction shown by d in FIG. 19a.

In addition, as shown in FIG. 19a, when the electronic device is in the closed state, an included angle between the fifth direction and the sixth direction is greater than 0°, so that the second housing fastening bracket 10223 and the second support plate 10226 limit a motion of the fourth support plate 10227 toward the base. In this way, fall-off of the third support plate 10217 can be avoided.

Still refer to FIG. 19b. When the electronic device is in the closed state, the fourth support plate 10227 may avoid the second swing arm 10221, so that the hinge mechanism 1 may form, in the closed state, screen accommodating space that meets a bending requirement of a flexible display. In addition, the fourth support plate 10227 may further include a second abutting part 102273. Refer to FIG. 19a and FIG. 19b together. The second abutting part 102273 may be located between the second sliding part 102271 and the second support part 102272. When the electronic device is in the closed state, the second abutting part 102273 abuts against the second housing fastening bracket 10223. In this way, the second housing fastening bracket 10223 provides support force for the second abutting part 102273 in a direction away from the base 101, and the second housing fastening bracket 10223 provides support force for the fourth support plate 10227 in a direction away from the base 101, to prevent the fourth support plate 10227 from falling off. This improves structural reliability of the second rotating assembly 1022 and further improves structural reliability of the hinge mechanism 1.

As shown in FIG. 4, in this application, the second support part 102272 includes a sixth plate surface 1022721. In addition, refer to FIG. 20. When an electronic device is in an unfolded state shown in FIG. 20, the fourth support plate 10227 may be located on a side that is of the second swing arm 10221 and that faces the flexible display, and the third plate surface 102261 and the sixth plate surface 1022721 are connected to form a support surface for supporting the flexible display. This helps improve integrity of the support surface that is of the hinge mechanism 1 and that is configured to support the flexible display, thereby implementing smoothly supporting the flexible display.

The hinge mechanism 1 provided in the foregoing embodiments of this application may be used in, for example, the electronic device shown in FIG. 1 or FIG. 2. The first housing fastening bracket 10213 may be fastened to a housing on a same side as the base 101, and the second housing fastening bracket 10223 may be fastened to another housing. For example, the first housing fastening bracket 10213 may be configured to be fastened to the first housing 2 of the electronic device shown in FIG. 2, and the second housing fastening bracket 10223 may be configured to be fastened to the second housing 3 of the electronic device shown in FIG. 2. Based on this, it may be understood that, a process in which the first housing fastening bracket 10213 and the second housing fastening bracket 10223 rotate toward or away from each other is a process in which the first housing 2 and the second housing 3 rotate toward or against each other.

In addition, the flexible display 4 of the electronic device may be fastened to the first housing 2 and the second housing 3, and a connection manner may be but is not limited to bonding. During specific implementation, the flexible display 4 may be bonded to a part of a surface that is of the first housing 2 and that faces the flexible display 4, and the flexible display 4 may be bonded to a part of a surface that is of the second housing 3 and that faces the flexible display 4, so that when the electronic device is in the unfolded state, the hinge mechanism 1, the first housing 2, and the second housing 3 can jointly support the flexible display 4 smoothly. In this way, it may be ensured that the electronic device has a complete form in the unfolded state. In a process in which the electronic device changes from the unfolded state to a closed state, the two housings may rotate toward each other to drive the flexible display 4 to rotate. This can effectively avoid deformation of the flexible display 4, to reduce a risk of damage to the flexible display 4.

It should be understood that, to implement the form of the electronic device, this application is not limited to embodiments of the hinge mechanism 1 mentioned above, provided that the hinge mechanism 1 in the following states can be implemented:

When the electronic device is in the unfolded state, the hinge mechanism 1, the first housing 2, and the second housing 3 may jointly support the flexible display 4 smoothly. In a process in which the electronic device changes from the unfolded state to the closed state, the two housings of the electronic device may rotate toward each other, to drive the flexible display 4 to bend. In a process in which the electronic device changes from the closed state to the unfolded state, the two housings of the electronic device may rotate away from each other, to drive the flexible display 4 to unfold.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A hinge mechanism, used in a foldable electronic device, wherein the hinge mechanism is disposed relative to a foldable part of a flexible display of the electronic device, the electronic device is unfolded or closed by using the hinge mechanism, the hinge mechanism comprises a base and a rotating module, the rotating module comprises a first rotating assembly and a second rotating assembly, the first rotating assembly and the second rotating assembly are respectively disposed on two opposite sides of the base, a side that is of the base and that is away from the flexible display comprises an appearance housing, and the appearance housing comprises a first end and a second end that are opposite to each other, wherein
the first rotating assembly comprises a first swing arm, a first housing fastening bracket, a first radial rotating arm, and a first support arm; the first swing arm is rotatably connected to the base; the first support arm is rotatably connected to the base, the first support arm is slidably connected to the first housing fastening bracket in a first direction, an axis through which the first support arm rotates around the base and an axis through which the first swing arm rotates around the base are both parallel to a length direction of the base and do not coincide with each other, and the first direction is perpendicular to the length direction of the base; the first radial rotating arm is located between the first swing arm and the first housing fastening bracket, the first radial rotating arm comprises a first connection part, a second connection part, and a first avoidance opening, the first avoidance opening is located between the first connection part and the second connection part, a surface that is of the first radial rotating arm and that is away from the first avoidance opening is a first connection surface, the first connection part is rotatably connected to the first swing arm, the second connection part is rotatably connected to the first housing fastening bracket, and a rotation axis of the first radial rotating arm extends in the first direction; and the first end of the appearance housing is disposed facing the first housing fastening bracket;
the second rotating assembly comprises a second swing arm, a second housing fastening bracket, a second radial rotating arm, and a second support arm; the second swing arm is rotatably connected to the base; the second support arm is rotatably connected to the base, the second support arm is slidably connected to the second housing fastening bracket in a second direction, an axis through which the second support arm rotates around the base and an axis through which the second swing arm rotates around the base are both parallel to the length direction of the base and do not coincide with each other, and the second direction is perpendicular to the length direction of the base; the second radial rotating arm is located between the second swing arm and the second housing fastening bracket, the second radial rotating arm comprises a third connection part, a fourth connection part, and a second avoidance opening, the second avoidance opening is located between the third connection part and the fourth connection part, a surface that is of the second radial rotating arm and that is away from the second avoidance opening is a second connection surface, the third connection part is rotatably connected to the second swing arm, the fourth connection part is rotatably connected to the second housing fastening bracket, and a rotation axis of the second radial rotating arm extends in the second direction; and the second end of the appearance housing is disposed facing the second housing fastening bracket; and
when the electronic device is in an unfolded state, the first end of the appearance housing is inserted into the first avoidance opening, and the second end of the appearance housing is inserted into the second avoidance opening; in a process in which the electronic device is switched from the unfolded state to a closed state, the first housing fastening bracket slides relative to the first support arm in a direction away from the base, the second housing fastening bracket slides relative to the second support arm in a direction away from the base, the first support arm rotates around the base to drive the first radial rotating arm to rotate around the first direction, and the second support arm rotates around the base to drive the second radial rotating arm to rotate around the second direction, so that when the electronic device is in the closed state, the first connection surface of the first radial rotating arm does not face the flexible display, and the second connection surface of the second radial rotating arm does not face the flexible display.

2. The hinge mechanism according to claim 1, wherein the first radial rotating arm further comprises a first avoidance part, the first avoidance part is located between the first connection part and the second connection part, and the first connection part and the second connection part are connected by using the first avoidance part; and the first avoidance part and the first avoidance opening are disposed away from each other, and the first connection surface is a surface that is of the first avoidance part and that is away from the first avoidance opening; and
the second radial rotating arm further comprises a second avoidance part, the second avoidance part is located between the third connection part and the fourth connection part, and the third connection part and the fourth connection part are connected by using the second avoidance part; and the second avoidance part and the second avoidance opening are disposed away from each other, and the second connection surface is a surface that is of the second avoidance part and that is away from the second avoidance opening.

3. The hinge mechanism according to claim 1 or 2, wherein the first connection part is rotatably connected to the first swing arm by using a first rotating shaft, the second connection part is rotatably connected to the first housing fastening bracket by using a second rotating shaft, an axis of the first rotating shaft extends in the first direction, and an axis of the second rotating shaft extends in the first direction; and
the third connection part is rotatably connected to the second swing arm by using a third rotating shaft, the fourth connection part is rotatably connected to the second housing fastening bracket by using a fourth rotating shaft, an axis of the third rotating shaft extends in the second direction, and an axis of the fourth rotating shaft extends in the second direction.

4. The hinge mechanism according to claim 3, wherein the second connection part is provided with a first clamping slot, the first housing fastening bracket is provided with a first clamping part, the first clamping part is inserted into the first clamping slot, and the second rotating shaft penetrates a slot wall of the first clamping slot and the first clamping part; and
the fourth connection part is provided with a second clamping slot, the second housing fastening bracket is provided with a second clamping part, the second clamping part is inserted into the second clamping slot, and the fourth rotating shaft penetrates a slot wall of the second clamping slot and the second clamping part.

5. The hinge mechanism according to any one of claims 1 to 4, wherein the first radial rotating arm further comprises a first track slot; and the first support arm comprises a first guide part, and the first guide part slides along the first track slot to drive the first radial rotating arm to rotate relative to the first swing arm, so that when the electronic device is in the unfolded state, the first end is inserted into the first avoidance opening; and
the second radial rotating arm further comprises a second track slot; and the second support arm comprises a second guide part, and the second guide part slides along the second track slot to drive the second radial rotating arm to rotate relative to the second swing arm, so that when the electronic device is in the unfolded state, the second end is inserted into the second avoidance opening.

6. The hinge mechanism according to claim 5, wherein the first track slot is a spiral slot, and the second track slot is a spiral slot.

7. The hinge mechanism according to claim 5 or 6, wherein the first connection part is provided with a first avoidance surface, and the third connection part is provided with a second avoidance surface; and when the electronic device is in the closed state, the first avoidance surface of the first radial rotating arm faces the flexible display and avoids the foldable part of the flexible display, and the second avoidance surface of the second radial rotating arm faces the flexible display and avoids the foldable part of the flexible display.

8. The hinge mechanism according to claim 7, wherein the first guide part slides along the first track slot to drive the first radial rotating arm to rotate relative to the first swing arm, so that when the electronic device is in the closed state, the first avoidance surface faces the flexible display and avoids the foldable part of the flexible display; and
the second guide part slides along the second track slot to drive the second radial rotating arm to rotate relative to the second swing arm, so that when the electronic device is in the closed state, the second avoidance surface faces the flexible display and avoids the foldable part of the flexible display.

9. The hinge mechanism according to claim 7 or 8, wherein the first avoidance surface is an arc-shaped concave surface, and the second avoidance surface is an arc-shaped concave surface.

10. The hinge mechanism according to any one of claims 1 to 9, wherein the base is provided with a first arc-shaped groove and a second arc-shaped groove, the first swing arm comprises a first arc-shaped rotating block, the first arc-shaped rotating block is accommodated in the first arc-shaped groove, and the first arc-shaped rotating block is capable of sliding along a groove surface of the first arc-shaped groove; and
the second swing arm comprises a second arc-shaped rotating block, the second arc-shaped rotating block is accommodated in the second arc-shaped groove, and the second arc-shaped rotating block is capable of sliding along a groove surface of the second arc-shaped groove.

11. The hinge mechanism according to any one of claims 1 to 10, wherein the first housing fastening bracket is provided with a first sliding slot, the first support arm is accommodated in the first sliding slot, and the first support arm is capable of sliding in the first sliding slot in the first direction; and
the second housing fastening bracket is provided with a second sliding slot, the second support arm is accommodated in the second sliding slot, and the second support arm is capable of sliding in the second sliding slot in the second direction.

12. The hinge mechanism according to claim 11, wherein the first housing fastening bracket further comprises a first mounting slot, a slot wall of the first mounting slot is provided with a first notch, and the first mounting slot communicates with the first sliding slot through the first notch; the hinge mechanism further comprises a first damping module, the first damping module comprises a first elastic member and a first damping bracket, the first damping bracket comprises a first protrusion, the first damping bracket is mounted in the first mounting slot, and under an action of elastic force of the first elastic member, the first protrusion is capable of sliding along the first notch and extending into the first sliding slot; and a surface that is of the first support arm and that faces the first mounting slot is further provided with a second protrusion, and when the first protrusion extends into the first sliding slot, opposite side surfaces of the first protrusion and the second protrusion abut against each other in the first direction; and
the second housing fastening bracket further comprises a second mounting slot, a slot wall of the second mounting slot is provided with a second notch, and the second mounting slot communicates with the second sliding slot through the second notch; the hinge mechanism further comprises a second damping module, the second damping module comprises a second elastic member and a second damping bracket, the second damping bracket comprises a third protrusion, the second damping bracket is mounted in the second mounting slot, and under an action of elastic force of the second elastic member, the third protrusion is capable of sliding along the second notch and extending into the second sliding slot; and a surface that is of the second support arm and that faces the second mounting slot is further provided with a fourth protrusion, and when the third protrusion extends into the second sliding slot, opposite side surfaces of the third protrusion and the fourth protrusion abut against each other in the second direction.

13. The hinge mechanism according to claim 12, wherein the first support arm comprises two first connection arms that are disposed opposite to each other, the two first connection arms are slidably connected to the first housing fastening bracket, and the first damping module is located between the two first connection arms; and
the second support arm comprises two second connection arms that are disposed opposite to each other, the two second connection arms are slidably connected to the second housing fastening bracket, and the second damping module is located between the two second connection arms.

14. The hinge mechanism according to any one of claims 1 to 13, wherein the first rotating assembly further comprises a first support plate, the first support plate comprises a first plate surface and a second plate surface that are disposed back to back, the first plate surface is configured to support the flexible display, the second plate surface is provided with a third track slot, the first support arm is provided with a first guide structure, the first guide structure is inserted into the third track slot, and the first guide structure is capable of sliding along the third track slot;
the second rotating assembly further comprises a second support plate, the second support plate comprises a third plate surface and a fourth plate surface that are disposed back to back, the third plate surface is configured to support the flexible display, the fourth plate surface is provided with a fourth track slot, the second support arm is provided with a second guide structure, the second guide structure is inserted into the fourth track slot, and the second guide structure is capable of sliding along the fourth track slot; and
when the first housing fastening bracket and the second housing fastening bracket rotate toward each other, the first housing fastening bracket drives the first support arm to rotate around the base, and the first guide structure slides along the third track slot, to drive the first support plate to rotate relative to the first housing fastening bracket, and drive an end that is of the first support plate and that is close to the base to move in a direction away from the base; and the second housing fastening bracket drives the second support arm and the second swing arm to rotate around the base, and the second guide structure slides along the third track slot, to drive the second support plate to rotate relative to the second housing fastening bracket, and drive an end that is of the second support plate and that is close to the base to move in a direction away from the base, so that screen accommodating space for accommodating a bendable part of the flexible display is formed between the first support plate, the base, and the second support plate.

15. The hinge mechanism according to claim 14, wherein the first housing fastening bracket further comprises a fifth track slot, the first rotating assembly further comprises a third support plate, the third support plate comprises a first sliding part and a first support part, the first sliding part is inserted into the fifth track slot, the first housing fastening bracket rotates around the base to drive the third support plate to rotate around the base, and the first sliding part slides along the fifth track slot; the first support plate comprises a third sliding slot, the first support part is capable of sliding along the third sliding slot, and the first support part comprises a fifth plate surface for supporting the flexible display; when the electronic device is in the closed state, the third support plate avoids the first swing arm; and when the electronic device is in the unfolded state, the third support plate is located on a side that is of the first swing arm and that faces the flexible display, and the first plate surface and the fifth plate surface are connected to form a support surface for supporting the flexible display; and
the second housing fastening bracket further comprises a sixth track slot, the second rotating assembly further comprises a fourth support plate, the fourth support plate comprises a second sliding part and a second support part, the second sliding part is inserted into the sixth track slot, the second housing fastening bracket rotates around the base to drive the fourth support plate to rotate around the base, and the second sliding part slides along the sixth track slot; the second support plate comprises a fourth sliding slot, the second support part is capable of sliding along the fourth sliding slot, and the second support part comprises a sixth plate surface for supporting the flexible display; when the electronic device is in the closed state, the fourth support plate avoids the second swing arm; and when the electronic device is in the unfolded state, the fourth support plate is located on a side that is of the second swing arm and that faces the flexible display, and the third plate surface and the sixth plate surface are connected to form a support surface for supporting the flexible display.

16. The hinge mechanism according to claim 15, wherein the fifth track slot is a linear slot, the third sliding slot is a linear slot, the first sliding part is capable of sliding in the fifth track slot relative to the first housing fastening bracket in a third direction, the first support part is capable of sliding in the third sliding slot relative to the first support plate in a fourth direction, and when the electronic device is in the closed state, an included angle between the third direction and the fourth direction is greater than 0°; and
the sixth track slot is a linear slot, the fourth sliding slot is a linear slot, the second sliding part is capable of sliding in the sixth track slot relative to the second housing fastening bracket in a fifth direction, the second support part is capable of sliding in the fourth sliding slot relative to the second support plate in a sixth direction, and when the electronic device is in the closed state, an included angle between the fifth direction and the sixth direction is greater than 0°.

17. The hinge mechanism according to claim 15 or 16, wherein the third support plate further comprises a first abutting part, and when the electronic device is in the closed state, the first abutting part abuts against the first housing fastening bracket, and the first housing fastening bracket provides support force for the first abutting part in a direction away from the base; and
the fourth support plate further comprises a second abutting part, and when the electronic device is in the closed state, the second abutting part abuts against the second housing fastening bracket, and the second housing fastening bracket provides support force for the second abutting part in a direction away from the base.

18. The hinge mechanism according to any one of claims 14 to 17, wherein the base comprises a bearing surface, the bearing surface is configured to support the flexible display, and when the electronic device is in the closed state, the bearing surface, the first support surface, and the third support surface are connected to form a support surface for supporting the flexible display.

19. An electronic device, comprising a first housing, a second housing, a flexible display, and the hinge mechanism according to any one of claims 1 to 18, wherein the first housing and the second housing are respectively disposed on two opposite sides of the hinge mechanism, a first housing fastening bracket is fastened to the first housing, and a second housing fastening bracket is fastened to the second housing; and
the flexible display continuously covers the first housing, the second housing, and the hinge mechanism, and the flexible display is fastened to the first housing and the second housing.
